(19) Europäisches Patentamt / European Patent Office / Office européen des brevets

(11) **EP 4 109 794 A1**

(12) **EUROPEAN PATENT APPLICATION**
published in accordance with Art. 153(4) EPC

(43) Date of publication:
**28.12.2022 Bulletin 2022/52**

(21) Application number: **21767474.6**

(22) Date of filing: **12.03.2021**

(51) International Patent Classification (IPC):
**H04L 1/00** (2006.01)

(52) Cooperative Patent Classification (CPC):
**H03M 13/11; H04L 1/00**

(86) International application number:
**PCT/CN2021/080532**

(87) International publication number:
**WO 2021/180217 (16.09.2021 Gazette 2021/37)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **13.03.2020 CN 202010177240**

(71) Applicant: HUAWEI TECHNOLOGIES CO., LTD.
**Shenzhen Guangdong 518129 (CN)**

(72) Inventors:
• LIN, Wei
  **Shenzhen, Guangdong 518129 (CN)**
• WANG, Hui
  **Chengdu, Sichuan 611756 (CN)**
• GAN, Ming
  **Shenzhen, Guangdong 518129 (CN)**
• LEI, Xianfu
  **Chengdu, Sichuan 611756 (CN)**
• TANG, Xiaohu
  **Chengdu, Sichuan 610031 (CN)**

(74) Representative: **Maiwald GmbH**
**Elisenhof**
**Elisenstraße 3**
**80335 München (DE)**

(54) **RATE MATCHING METHOD FOR LDPC CODE, AND COMMUNICATION DEVICE**

(57) This application provides an LDPC code rate matching method and a communication apparatus. A transmit end punctures an LDPC codeword based on a priority order of check bits of a mother code of an LDPC code. This can avoid impact of check bits at some highly sensitive bit positions on another check bit or avoid incorrect transfer, and improve decoding performance of a receive end.

400

Perform rate matching on a first LDPC codeword with a first code rate based on a priority order of check bits of a mother code of an LDPC code, to obtain a second LDPC codeword with a second code rate, where the priority order indicates sorting of priorities of puncturing the check bits of the mother code during rate matching — 410

Send the second LDPC codeword — 420

FIG. 4

EP 4 109 794 A1

**Description**

This application claims priority to Chinese Patent Application No. 202010177240.4, filed with the China National Intellectual Property Administration on March 13, 2020 and entitled "LDPC CODE RATE MATCHING METHOD AND COMMUNICATION APPARATUS", which is incorporated herein by reference in its entirety.

**TECHNICAL FIELD**

This application relates to the field of channel coding, and more specifically, to an LDPC code rate matching method and a communication apparatus.

**BACKGROUND**

In the field of channel coding, a low-density parity check (low-density parity check, LDPC) code is a most mature and widely applied channel coding scheme. The LDPC code has performance close to the Shannon limit, and has many advantages. Therefore, IEEE 802.11n, 802.11ac, 802.11ax, and other protocols propose that the LDPC code be used as a standard channel coding scheme for a wireless local area network (wireless local area network, WLAN). Currently, a total of 12 check matrices of the LDPC code are used in the 802.11ac/ax standard. There are three types of code lengths, and each code length supports four code rates. A transmit device selects a corresponding check matrix from the 12 check matrices based on a target code length and code rate, to perform LDPC encoding.

To further improve a throughput rate of a communication system, a next-generation WLAN standard 802.11be is proposed, and an incremental redundancy-hybrid automatic repeat request (incremental redundancy-hybrid automatic repeat request, IR-HARQ) mechanism is introduced based on 802.11ax. The IR-HARQ mechanism expects to increase a redundant bit through retransmission and reduce a channel coding rate, to improve decoding performance of a receive end.

However, the foregoing coding scheme used in the current WLAN standard cannot meet a requirement of continuously increasing redundant bits through retransmission in the IR-HARQ mechanism to reduce a channel coding rate and improve decoding performance.

This application provides an LDPC code rate matching method and a communication apparatus, to improve decoding performance.

According to a first aspect, this application provides an LDPC code rate matching method. The method includes: A transmit end performs rate matching on a first LDPC codeword with a first code rate based on a priority order of check bits of a mother code of an LDPC code, to obtain a second LDPC codeword with a second code rate, where the priority order indicates sorting of priorities of puncturing the check bits of the mother code during rate matching. The transmit end sends the second LDPC codeword.

In the technical solutions of this application, the transmit end performs rate matching on the LDPC codeword based on the priority order of puncturing the check bits of the mother code of the LDPC code during rate matching. A check bit with a high priority is a sensitive bit that is easily affected by noise, and may affect an iteration process of a variable node and a check node in an iterative decoding process. Therefore, the check bits of the LDPC codeword are punctured based on the priority order, and the check bit with high sensitivity may be preferentially punctured. In this way, incorrect transfer caused by an error of these check bits in an iterative decoding process is avoided, impact on another variable node or check node is reduced. This can improve puncturing performance, and improve decoding performance.

In addition, the transmit end punctures an LDPC codeword with a low code rate based on the priority order of the check bits of the mother code of the LDPC code, to obtain an LDPC codeword that is compatible with the low code rate and that has a higher code rate. Alternatively, the transmit end punctures a check bit corresponding to a puncturing position of an LDPC codeword with a high code rate based on the priority order of the check bits of the mother code, to obtain an LDPC codeword with a low code rate, and may obtain more LDPC codewords with low code rates. Therefore, the technical solutions of this application are also applicable to an enhanced link adaptation scenario. Two communication parties may select an appropriate code rate for communication based on a link status, to select a code rate at a finer granularity.

With reference to the first aspect, in some implementations of the first aspect, that a transmit end performs rate matching on a first LDPC codeword with a first code rate based on a priority order of check bits of a mother code includes: The transmit end punctures, based on a required quantity L of to-be-punctured bits and the priority order of the check bits of the mother code, check bits that are corresponding to first L bit positions sorted in descending order of priorities and that are in the first LDPC codeword, where $L \geq 1$, and N is an integer.

It should be understood that priorities of the check bits at the L bit positions are all higher than priorities of remaining check bits.

With reference to the first aspect, in some implementations of the first aspect, the priority order indicates an order of priorities of columns corresponding to the check bits in a check matrix of the mother code. Each column corresponding to a check bit in the check matrix of the mother code is corresponding to z check bits of the mother code. z = N/n, N is a code length of the mother code, and n indicates a total quantity of columns included in the check matrix of the mother code.

With reference to the first aspect, in some implementations of the first aspect, the code length of the mother code is 1944, a code rate is 1/2, and priorities of the columns corresponding to the check bits in the check matrix of the mother code are sorted in descending order as follows:

19, 20, 18, 21, 17, 22, 16, 23, 15, 24, 14, and 13, where each element a in the sorting indicates an $a^{th}$ column of the check matrix of the mother code.

With reference to the first aspect, in some implementations of the first aspect, the code length of the mother code is 1296, a code rate is 1/2, and priorities of the columns corresponding to the check bits in the check matrix of the mother code are sorted in descending order as follows:

20, 15, 21, 14, 19, 23, 16, 24, 18, 22, 17, and 13, where each element a in the sorting indicates an $a^{th}$ column of the check matrix of the mother code.

With reference to the first aspect, in some implementations of the first aspect, the code length of the mother code is 648, a code rate is 1/2, and priorities of the columns corresponding to the check bits in the check matrix of the mother code are sorted in descending order as follows:

21, 15, 22, 23, 18, 19, 14, 24, 20, 16, 17, and 13, where each element a in the sorting indicates an $a^{th}$ column of the check matrix of the mother code.

In the foregoing embodiments, a column index of the check matrix of the mother code is sequentially numbered from 1. For example, for the mother code whose code rate is 1/2 and whose code length is 1944, 1296, or 648, a column index range of the check matrix of the mother code is [1, 24].

Optionally, in some embodiments, a column index of the check matrix of the mother code may alternatively be sequentially numbered from 0. In this case, for the mother code whose code rate is 1/2 and whose code length is 1944, 1296, or 648 in this embodiment of this application, a column index range of the check matrix of the mother code is [0, 23].

It should be understood that check matrices represented by different column index ranges are equivalent.

With reference to the first aspect, in some implementations of the first aspect, priorities of the z check bits corresponding to each column corresponding to the check bit in the check matrix of the mother code are the same.

With reference to the first aspect, in some implementations of the first aspect, that the transmit end punctures, based on a required quantity L of to-be-punctured bits and the priority order of the check bits of the mother code, check bits that are corresponding to first L bit positions sorted in descending order of priorities and that are in the first LDPC codeword includes:

If L < z, the transmit end punctures, based on the priority order, N check bits in z check bits corresponding to a column with a highest priority in the check matrix of the mother code.

Alternatively, if L > z, the transmit end punctures, based on the priority order, L check bits in tz check bits corresponding to first t columns whose priorities are in descending order and that are in the check matrix of the mother code, where the L check bits include z(t-1) check bits corresponding to first (t-1) columns in the t columns and p check bits in a $t^{th}$ column, the p check bits are any p check bits in z check bits corresponding to the $t^{th}$ column, both t and p are positive numbers, and p $\leq$ z.

Alternatively, if L = mz, the transmit end punctures, based on the priority order, mz check bits corresponding to m columns with highest priorities in the check matrix of the mother code, where m $\geq$ 1 and m is an integer.

It should be noted that "m columns with highest priorities in the check matrix of the mother code" described in this embodiment of this application indicates that in all columns of the check matrix of the mother code, a priority of a column with a lowest priority in the m columns is higher than a priority of a column with a highest priority in remaining columns other than the m columns in the check matrix.

For example, it is assumed that the code rate of the mother code is 1/2, and the code length is 1944. In this case, the check matrix of the mother code includes 24 columns (refer to the specification), where columns corresponding to check bits are a $13^{th}$ column to a $24^{th}$ column. It is assumed that a priority order of the $13^{th}$ column to the $24^{th}$ column in descending order of priorities is 19, 20, 18, 21, 17, 22, 16, 23, 15, 24, 14, and 13. In this case, four columns with highest priority are the $19^{th}$ column, the $20^{th}$ column, the $18^{th}$ column, and the $21^{th}$ column.

With reference to the first aspect, in some implementations of the first aspect, after the transmit end sends the second LDPC codeword, the method further includes: The transmit end receives retransmission indication information. The transmit end performs rate matching on a to-be-retransmitted codeword based on the priority order of the check bits of the mother code, to obtain a third LDPC codeword with a third code rate, where the to-be-retransmitted codeword is obtained by performing LDPC encoding on to-be-retransmitted bits, and a puncturing position set of check bits of the third LDPC codeword is a proper subset of a puncturing position set of check bits of the second LDPC codeword. The transmit end sends the third LDPC codeword.

According to a second aspect, this application provides an LDPC code decoding method. The method includes:

A receive end receives a first channel receiving sequence. The receive end pads, with zeros based on a priority order of check bits of a mother code of an LDPC code, corresponding puncturing positions of a first LLR sequence corresponding to the first channel receiving sequence, and decodes a first LLR sequence obtained through zero-padding. The corresponding puncturing positions of the first LLR sequence are positions of check bits that are punctured in a rate matching process in an LDPC codeword corresponding to the first channel receiving sequence. The receive end requests a transmit end to perform retransmission if a system bit of the LDPC codeword fails to be obtained through decoding.

It may be understood that, when the receive end successfully decodes the system bit of the LDPC code, the receive end outputs a decoding result.

With reference to the second aspect, in some implementations of the second aspect, the check bit that is punctured during rate matching process in the LDPC codeword is a check bit corresponding to first L bit positions with highest priorities in the priority order, L is a quantity of check bits that need to be punctured, and L is an integer.

It should be understood that the L bit positions with the highest priorities are first L bit positions in descending order of priorities.

With reference to the second aspect, in some implementations of the second aspect, the priority order indicates sorting of priorities of columns corresponding to the check bits in a check matrix of the mother code of the LDPC. Each column corresponding to a check bit in the check matrix is corresponding to z codeword bits of the mother code. z = N/n, N indicates a code length of the mother code, n indicates a total quantity of columns included in the check matrix of the mother code, and N and n are integers.

With reference to the second aspect, in some implementations of the second aspect, the length of the mother code is 1944, a code rate is 1/2, and priorities of the columns corresponding to the check bits in the check matrix of the mother code are sorted in descending order as follows:

19, 20, 18, 21, 17, 22, 16, 23, 15, 24, 14, and 13.

Each element a in the sorting indicates an $a^{th}$ column of the check matrix.

With reference to the second aspect, in some implementations of the second aspect, the length of the mother code is 1296, a code rate is 1/2, and priorities of the columns corresponding to the check bits in the check matrix of the mother code are sorted in descending order as follows:

20, 15, 21, 14, 19, 23, 16, 24, 18, 22, 17, and 13.

Each element a in the sorting indicates an $a^{th}$ column of the check matrix.

With reference to the second aspect, in some implementations of the second aspect, the length of the mother code is 648, a code rate is 1/2, and priorities of the columns corresponding to the check bits in the check matrix of the mother code are sorted in descending order as follows:

21, 15, 22, 23, 18, 19, 14, 24, 20, 16, 17, and 13.

Each element a in the sorting indicates an $a^{th}$ column of the check matrix.

With reference to the second aspect, in some implementations of the second aspect, priorities of the z codeword bits corresponding to each column corresponding to the check bit in the check matrix of the mother code are the same.

With reference to the second aspect, in some implementations of the second aspect, the check bit that is punctured during rate matching process in the LDPC codeword corresponding to the first channel receive sequence meets one of the following cases:

If L < z, the punctured check bit is any L check bits in z check bits corresponding to a column with a highest priority in the check matrix.

Alternatively, if L > z, the punctured check bit is L check bits in check bits corresponding to first t columns sorted in descending order in the check matrix, where the L check bits include z(t-1) check bits corresponding to first (t-1) columns and p check bits in a $t^{th}$ column, the p check bits are any p check bits in z check bits corresponding to the $t^{th}$ column, both t and p are positive numbers, and $p \leq z$.

Alternatively, if L = mz, the punctured check bit is mz check bits corresponding to m columns with highest priorities in the check matrix.

With reference to the second aspect, in some implementations of the second aspect, that the receive end requests a transmit end to perform retransmission if a system bit of the LDPC codeword corresponding to the first channel receiving sequence fails to be obtained through decoding includes:

The receive end sends retransmission indication information to the transmit end.

The receive end receives a second channel receiving sequence.

The receive end pads, with zeros based on the priority order of the check bits of the LDPC code, corresponding puncturing positions in a second LLR sequence corresponding to the second channel receiving sequence, and decodes a combined sequence of a second LLR sequence obtained through zero-padding and the first LLR sequence obtained through zero-padding. A set including puncturing positions that need to be padded with zeros in the second LLR sequence is a proper subset of a set including puncturing positions that need to be padded with zeros in the first LLR sequence. The puncturing positions that need to be padded with zeros in the second LLR sequence are first several puncturing positions that need to be padded with zeros in the first LLR sequence in ascending order of priorities.

It should be noted that, that the puncturing positions that need to be padded with zeros in the second LLR sequence are the first several puncturing positions that need to be padded with zeros in ascending order of priorities in the first LLR sequence. It indicates that the set of puncturing positions that need to be padded with zeros in the first LLR sequence completely includes the set of the puncturing positions that need to be padded with zeros in the second LLR sequence. In addition, the puncturing positions that need to be padded with zeros in the second LLR sequence are the first several puncturing positions sorted in ascending order of the puncturing positions that need to be padded with zeros in the first LLR sequence.

For example, the set of puncturing positions that need to be padded with zeros in the first LLR sequence is $\{n_1, n_2, ..., n_T\}$. If the puncturing positions in the set are arranged in descending order of priorities, the puncturing positions that need to be padded with zeros in the second LLR column may be several puncturing positions in back-to-front order in the set $\{n_1, n_2, ..., n_T\}$. For example, if there are two puncturing positions that need to be padded with zeros in the second LLR sequence, the puncturing positions that need to be padded with zeros in the second LLR sequence are $n_T$ and $n_{T-1}$. For another example, if there are four puncturing positions that need to be padded with zeros in the second LLR sequence, the puncturing positions that need to be padded with zeros in the second LLR sequence are $n_T$, $n_{T-1}$, $n_{T-2}$, and $n_{T-3}$.

According to a third aspect, this application provides a communication apparatus. The communication apparatus has a function of implementing the method according to the first aspect and any one of the possible implementations of the first aspect. The function may be implemented by hardware, or may be implemented by hardware executing corresponding software. The hardware or the software includes one or more units corresponding to the foregoing functions.

According to a fourth aspect, this application provides a communication apparatus. The communication apparatus has a function of implementing the method according to the second aspect and any one of the possible implementations of the second aspect. The function may be implemented by hardware, or may be implemented by hardware executing corresponding software. The hardware or the software includes one or more units corresponding to the foregoing functions.

According to a fifth aspect, this application provides a communication apparatus. The communication apparatus includes an interface circuit and a processor. The interface circuit is configured to receive computer code or instructions, and transmit the computer code or the instructions to the processor. The processor runs the computer code or the instructions, and the method in the first aspect or any implementation of the first aspect is implemented.

According to a sixth aspect, this application provides a communication apparatus. The communication apparatus includes an interface circuit and a processor. The interface circuit is configured to receive computer code or instructions, and transmit the computer code or the instructions to the processor. The processor runs the computer code or the instructions, and the method in the second aspect or any implementation of the second aspect is implemented.

According to a seventh aspect, this application provides a communication device. The communication device includes at least one processor, and the at least one processor is coupled to at least one memory. The at least one memory is configured to store a computer program or instructions. The at least one processor is configured to invoke the computer program or the instructions from the at least one memory and run the computer program or the instructions, so that the communication device performs the method in the first aspect or any possible implementation of the first aspect.

In an example, the communication device may be an encoder.

According to an eighth aspect, this application provides a communication device. The communication device includes at least one processor, and the at least one processor is coupled to at least one memory. The at least one memory is configured to store a computer program or instructions. The at least one processor is configured to invoke the computer program or the instructions from the at least one memory and run the computer program or the instructions, so that the communication device performs the method in the second aspect or any possible implementation of the second aspect.

In an example, the communication device may be a decoder.

According to a ninth aspect, this application provides a computer-readable storage medium. The computer-readable storage medium stores computer instructions. When the computer instructions are run on a computer, the method according to the first aspect or any one of the possible implementations of the first aspect is implemented.

According to a tenth aspect, this application provides a computer-readable storage medium. The computer-readable storage medium stores computer instructions. When the computer instructions are run on a computer, the method according to the first aspect or any one of the possible implementations of the first aspect is implemented.

According to an eleventh aspect, this application provides a computer program product. The computer program product includes computer program code. When the computer program code is run on a computer, the method according to any one of the first aspect or the possible implementations of the first aspect is implemented.

According to a twelfth aspect, this application provides a computer program product. The computer program product includes computer program code. When the computer program code is run on a computer, the method according to any one of the first aspect or the possible implementations of the first aspect is implemented.

According to a thirteenth aspect, this application provides a wireless communication system. The wireless communication system includes the communication device according to the seventh aspect and the communication device according to the eighth aspect.

**BRIEF DESCRIPTION OF DRAWINGS**

FIG. 1 is a check matrix H of an LDPC code;
FIG. 2 is a Tanner graph of a check matrix H of an LDPC code;
(a) and (b) in FIG. 3 are diagrams of system architectures applicable to embodiments of this application;
FIG. 4 is a schematic flowchart of an LDPC code rate matching method according to this application;
FIG. 5 is a schematic diagram of a rate matching process of an LDPC code according to this application;
FIG. 6 is a schematic diagram of a decoding process at a receive end;
FIG. 7 is a flowchart of establishing a sensitivity sorting of check bits according to this application;
FIG. 8 is an image of a function;
FIG. 9 is an application example of an LDPC code rate matching method according to this application;
FIG. 10 to FIG. 23 are diagrams of comparisons between BER performance curves of LDPC codes with different quantities of to-be-punctured bits and BER performance curves of conventional puncturing solutions according to this application;
FIG. 24 is a schematic block diagram of a communication apparatus 600 according to this application; and
FIG. 25 is a schematic block diagram of another communication apparatus 800 according to this application.

**DESCRIPTION OF EMBODIMENTS**

The following describes technical solutions of this application with reference to accompanying drawings.
In the field of channel coding, a low-density parity check (low-density parity check, LDPC) code is a most mature and widely applied channel coding scheme. The LDPC code has performance close to a Shannon limit, and has many advantages, for example, good bit error performance without deep interleaving, good frame error rate performance, and a decoding delay because parallel decoding is supported. Therefore, IEEE 802.11n, 802.11ac, 802.11ax, and other protocols propose that the LDPC code be used as a standard channel coding scheme for a wireless local area network (wireless local area network, WLAN).
A next-generation wireless local area network (wireless local area network, WLAN) standard 802. llbe of 802.1 lax proposes to introduce a hybrid automatic repeat request (hybrid automatic repeat request, HARQ), to further improve a throughput rate of a system. The HARQ mainly involves storage, a retransmission request, and combination and demodulation. When failing to decode data, a receive end saves the received data, and requests a transmit end to retransmit data. The receive end combines the retransmitted data and the data that is previously received and stored, and then decodes the combined data. Through hierarchical gain, a probability of successful data decoding can be increased.
The HARQ may roughly include two types: chase combining (chase combine, CC) and incremental redundancy (incremental redundancy, IR), which may be referred to as a CC-HARQ and an IR-HARQ.
A HARQ mechanism may be considered as two types: chase combining (chase combine, CC) and incremental redundancy (incremental redundancy, IR). In a pure HARQ mechanism, the receive end directly discards a data packet that is not correctly received. However, although these data packets that are not correctly received cannot be decoded independently and correctly, the data packets still include a part of useful information. For CC-HARQ, in a CC process, the data packet that is not correctly received is stored in a memory by using the part of information, and the data packet is combined with a retransmitted data packet for decoding. This improves transmission efficiency. In the IR-HARQ mechanism, the transmit end sends an information bit and a part of redundant bits during initial transmission, and sends an additional redundant bit during retransmission. If decoding is not correctly performed during initial transmission, the transmit end retransmits more redundant bits to reduce a code rate of a channel, to improve a success rate of decoding. If the receive end still cannot correctly perform decoding based on the redundant bits in the first retransmission, the transmit end performs retransmission again. As a quantity of retransmissions increases, redundancy bits continuously increases, and the channel coding rate continuously decreases, so that a better decoding effect can be achieved.
If the IR-HARQ mechanism is introduced into the next-generation WLAN standard, the LDPC encoding scheme that is compatible with a plurality of rates are required for support, so that a new incremental redundancy bit can be introduced during retransmission.
To facilitate understanding of the solutions of this application, a concept related to an LDPC code is first described.
The LDPC code is a linear block code, and a check matrix of the LDPC code is a sparse matrix. In the check matrix of the LDPC code, a quantity of zero elements is far greater than a quantity of non-zero elements. In other words, a row weight and a column weight of the check matrix are very small compared with a code length of the LDPC code. An LDPC code whose information bit sequence length is equal to k and whose code length is equal to n may be uniquely determined by a check matrix of the LDPC code.

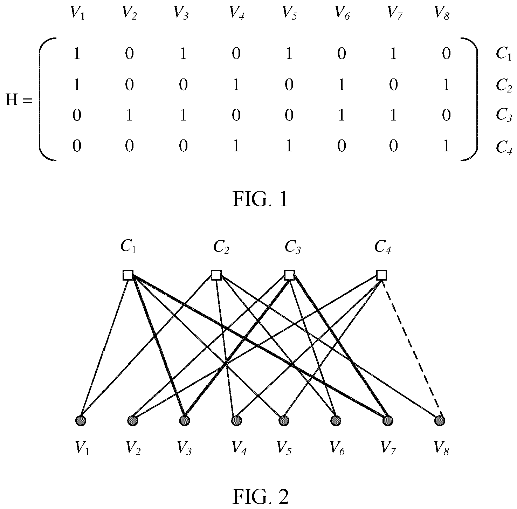

In 1981, Tanner graphically represented codewords of an LDPC code. Now, this type of graph is referred to as a Tanner graph. A Tanner graph and a check matrix are in a one-to-one correspondence. The Tanner graph includes two types of vertices. One type of vertex indicates a codeword bit, which is referred to as a variable node. The other type of vertex is a check node, which indicates a check constraint. Each check node indicates one check constraint. The following provides descriptions with reference to FIG. 1 and FIG. 2.

FIG. 1 is a check matrix H of an LDPC code. In FIG. 1, {Vi} indicates a variable node set, and {Ci} indicates a check node set. Each row of the check matrix H indicates one check equation, and each column indicates one codeword bit. In FIG. 1, there are eight variable nodes and four check nodes. If a codeword bit is included in a corresponding check equation, a bit node and a check node that are involved are connected by using a connection line, to obtain a Tanner graph.

FIG. 2 is a Tanner graph of a check matrix H of an LDPC code. As shown in FIG. 2, the Tanner graph indicates a check matrix of the LDPC code. For example, for the check matrix H with a size of m rows and n columns, the Tanner graph includes two types of nodes: n variable nodes and m check nodes. The n variable nodes are respectively corresponding to the n columns of the check matrix H, and the m check nodes are respectively corresponding to the m rows of the check matrix H. A cycle in the Tanner graph consists of connected vertices. The cycle uses one of the vertices as both a start point and an end point, and passes through each node only once. A length of the cycle is defined as a quantity of connection lines included in the cycle. A girth of a graph may also be referred to as a size of the graph, and is defined as a minimum cycle length in the graph. In FIG. 2, a girth is 6, as shown by a bold connection line in FIG. 2. The variable nodes in the Tanner graph each are corresponding to one column of the check matrix H, that is, corresponding to each codeword bit of the LDPC code. Check nodes in the Tanner graph each are corresponding to one row of the check matrix H, that is, corresponding to check bits of the LDPC code. A connection status between the two types of nodes is corresponding to a value of an element in the matrix H. If there is a connection between an $i^{th}$ check node and a $j^{th}$ variable node, it indicates that a value of an element (i, j) in the matrix H is 1. If there is no connection between an $i^{th}$ check node and a $j^{th}$ variable node, a corresponding element is 0.

In addition, in the Tanner graph, a cycle (cycle) is a closed cycle formed by a variable node, a check node, and an edge that are connected end-to-end.

The LDPC code is a linear block code. In the linear block code, a to-be-encoded information sequence is divided into groups in a unit of k bits, and an encoder performs a linear operation on the k information bits to obtain m check bits. Then, the k information bits are combined with the m check bits to obtain a code group whose length is n = k + m. A mapping relationship between the information bits of k bits and the code group whose length is n bits is usually represented by a corresponding check matrix H. An encoding sequence may be correspondingly generated based on the check matrix H, to complete an encoding process. After the encoding sequence is transmitted through a channel, a received signal is correspondingly decoded, to determine an original information bit.

When a code length is long, the check matrix H of the LDPC code is very large. Therefore, H is usually represented by blocks. The complete check matrix H is considered to be generated by using a plurality of submatrices of z×z. Therefore, the original check matrix H may be represented by using one base matrix $H_b$. Each element in $H_b$ is corresponding to one submatrix of z × z, and each submatrix may be represented by using a quantity of cyclic shift bits. Storage space required by the check matrix H is greatly reduced. Each check matrix is corresponding to one code rate and one code length.

In this embodiment of this application, a check matrix in an 802.11ac standard is used, and supports code lengths 1944, 1296, and 648. All the three code lengths support a code rate of 1/2. The check matrix H may be obtained based on a base matrix $H_b$ and a lifting factor z provided in the 802.11ac standard. The base matrix is expanded to the check matrix for encoding or decoding.

An LDPC code used in IEEE 802.11ac and 802.11ax standards is a quasi-cyclic low density parity check (quasi-cyclic low density parity check, QC-LDPC) code. The QC-LDPC code is a type of structured LDPC code. Because of a unique structure of the check matrix of the QC-LDPC code, a simple feedback shift register can be used for encoding, to reduce a complexity of encoding the LDPC code.

In IEEE 802.11ac and 802.11ax, a total of 12 check matrices of LDPC codes are used, which support three code lengths. The three code lengths are 648, 1296, and 1944. Each code length supports four code rates: 1/2, 2/3, 3/4, and 5/6. Check bit parts of the 12 check matrices all have a same structure.

For example, a check matrix H of an LDPC code whose code length is 1944 and whose code rate is 5/6 in 802.11ac is as follows:

$$\begin{bmatrix} 13 & 48 & 80 & 66 & 4 & 74 & 7 & 30 & 76 & 52 & 37 & 60 & - & 49 & - & 73 & 31 & 74 & 73 & 23 & 1 & 0 & - & - \\ 69 & 63 & 74 & 56 & 64 & 77 & 57 & 65 & 6 & 16 & 51 & - & 64 & - & 64 & 68 & 9 & 48 & 62 & 54 & - & 0 & 0 & - \\ 51 & 15 & 0 & 80 & 24 & 25 & 42 & 54 & 44 & 71 & 71 & 9 & 67 & 35 & 67 & - & 58 & - & 29 & - & 0 & - & 0 & 0 \\ 16 & 29 & 36 & 41 & 44 & 56 & 59 & 37 & 50 & 24 & - & 65 & 4 & 65 & 4 & 52 & - & 4 & - & 73 & 1 & - & - & 0 \end{bmatrix}$$

It can be learned that a size of H is 4 rows and 24 columns. Each element in the check matrix indicates a z = N/24-order square matrix, 0 in the matrix indicates an all-zero square matrix with a size of z×z, $P_z^i$ indicates a circular permutation matrix, i indicates a cyclic shift value, $0 \le i \le z - 1$, and i is an integer. In addition, "-" in the matrix indicates an all-zero matrix, and "0" indicates an identity matrix.

For example, $P_z^1$ is as follows:

$$\begin{bmatrix} 0 & 1 & 0 & \ldots & 0 \\ 0 & 0 & 1 & \ldots & 0 \\ \vdots & \vdots & \vdots & \ddots & \vdots \\ 0 & 0 & 0 & \cdots & 1 \\ 1 & 0 & 0 & \cdots & 0 \end{bmatrix}$$

When LDPC code encoding is performed in a WLAN, a transmit end selects a corresponding check matrix from the foregoing 12 check matrices based on a target code length and a target code rate. The 12 check matrices are different from each other.

To improve WLAN transmission reliability, an IR-HARQ mechanism is introduced in an IEEE 802.11be standard based on the previous 802.11ax standard. In the IR-HARQ mechanism, in order to obtain a higher throughput rate, a rate-compatible LDPC code needs to be introduced into the WLAN, to obtain an incremental redundancy bit during retransmission. In this way, a receive end obtains a performance gain by combining an initially received bit and the retransmitted incremental redundant bit.

The following describes the technical solutions provided in this application.

The technical solutions of this application are mainly applicable to a wireless communication system. The wireless communication system may comply with a 3rd generation partnership project (third generation partnership project, 3GPP) wireless communication standard, or may comply with another wireless communication standard, for example, an 802 series (for example, 802.11, 802.15, or 802.20) wireless communication standard of the institute of electrical and electronics engineers (institute of electrical and electronics engineers, IEEE).

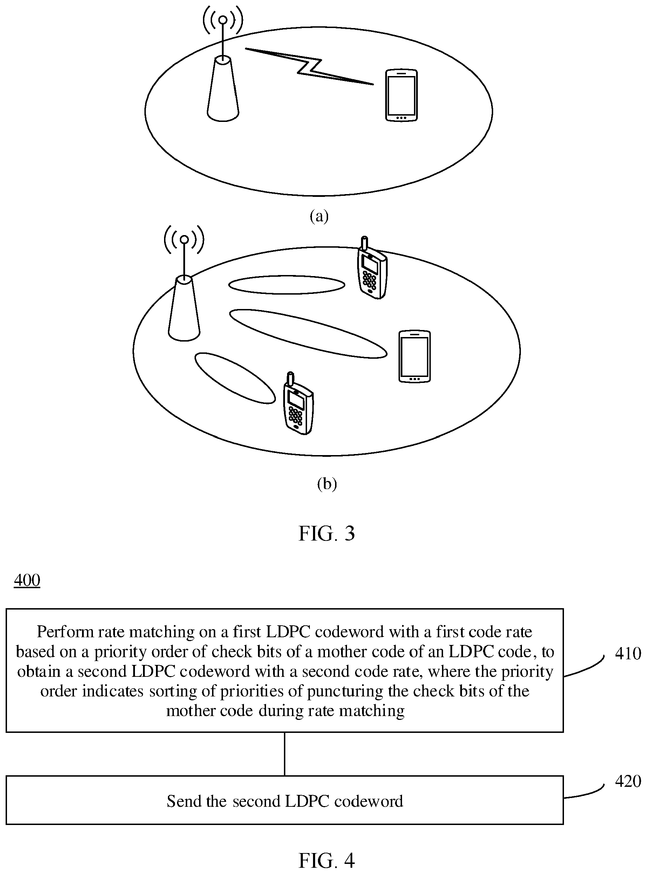

Refer to FIG. 3. (a) and (b) in FIG. 3 are diagrams of system architectures applicable to embodiments of this application. The wireless communication system includes at least one network device and one or more terminal devices. The at least one network device and the one or more terminal devices communicate with each other by using a wireless communication technology. For example, (a) in FIG. 3 shows communication between one network device and a single terminal device. (b) in FIG. 3 shows communication between one network device and a plurality of terminal devices. Optionally, the communication between the network device and the terminal device may further include downlink transmission in which the network device sends a signal to the terminal device and uplink transmission in which the terminal device sends a signal to the network device. This is not limited in this specification.

A terminal device in embodiments of this application is also referred to as user equipment (user equipment, UE), a terminal (terminal), a mobile phone (mobile phone), a tablet computer (tablet computer), a laptop computer (laptop computer), a wearable device (for example, a smartwatch, a smart band, a smart helmet, or smart glasses), and another device having a wireless access capability, for example, a smart car or various Internet of Things (Internet of Things, IoT) devices including various smart home devices (such as a smart meter and a smart home appliance) and smart city devices (such as a security or monitoring device and an intelligent road transportation facility), and a terminal device in a 5G system or a future communication system.

The network device in embodiments of this application may be a base station. The base station is sometimes referred to as a wireless access point (access point, AP), a transmission/reception point (transmission reception point, TRP), or a transmission point (transmission point, TP). Optionally, the base station may be a generation nodeB (generation NodeB, gNB) in a 5th generation (5th generation, 5G) system or an evolved nodeB (evolved NodeB, eNB) in a long term evolution (long term evolution, LTE) system. In addition, base stations may be classified into a macro base station (macro base station) or a micro base station (micro base station) based on different physical forms or transmit powers of the base stations. The micro base station is also sometimes referred to as a small base station or a small cell (small cell). In addition, the network device may alternatively be a network node that forms the gNB or the TRP, for example, a baseband unit (building baseband unit, BBU), a centralized unit (centralized unit, CU), or a distributed unit (distributed unit, DU).

To improve a system throughput rate, this application provides an LDPC code-based rate matching method, which is specifically a puncturing solution. If a check matrix of an LDPC code is reused, a check bit in an LDPC codeword is punctured, to obtain a code rate at a smaller granularity. A receive end may obtain a performance gain and improve decoding performance by combining codeword bits of different code rates.

FIG. 4 is a schematic flowchart of an LDPC code rate matching method according to this application.

410: A transmit end performs rate matching on a first LDPC codeword with a first code rate based on a priority order of check bits of a mother code, to obtain a second LDPC codeword with a second code rate.

The priority order indicates sorting of priorities of puncturing the check bits of the mother code during rate matching. In other words, the priority order of the check bits represents reliability of the check bits.

Lower reliability of a check bit indicates a higher priority in the sorting of the priorities of puncturing the check bit during rate matching, in other words, indicates a higher priority of puncturing the check bit. On the contrary, higher reliability of a check bit indicates a lower priority of puncturing the check bit during rate matching.

In an example, the priorities of the check bits are sorted in descending order of priorities. In this case, a check bit with lower reliability ranks higher in the priority order, and a check bit with higher reliability ranks lower in the priority order.

In another example, the priorities of the check bits may be alternatively sorted in ascending order of priorities. This is not limited in this specification. In this case, a check bit with lower reliability ranks lower in the priority order, and a check bit with higher reliability ranks higher in the priority order.

It should be understood that the mother code in this specification is an LDPC codeword obtained by performing LDPC encoding on system bits (system bits) based on a check matrix. In other words, the mother code is an LDPC codeword on which no rate matching is performed. In this specification, a code length of the mother code is denoted as N, and a code rate of the mother code is denoted as R.

In an embodiment, the first LDPC codeword may be the mother code. In this case, the first code rate of the first LDCP codeword is the code rate of the mother code. That is, LDPC encoding is performed on k system bits to obtain the first LDPC codeword, and a code rate of the first LDPC codeword is the first code rate.

The transmit end punctures the first LDPC codeword based on the priority order of the check bits of the mother code, to obtain the second LDPC codeword with a higher code rate.

In another embodiment, the first LDPC codeword may be an LDPC codeword after rate matching. For example, the first LDPC codeword may be an LDPC codeword obtained by puncturing the mother code. In this case, the first code rate of the first LDPC codeword is higher than the code rate of the mother code.

The transmit end punctures the first LDPC codeword based on the priority order of the check bits of the mother code, to obtain the second LDPC codeword. A code rate of the second LDPC codeword is higher than the first code rate.

Alternatively, the transmit end gradually fills a puncturing position of the first LDPC codeword based on the priority order of the check bits of the mother code, to gradually obtain an LDPC codeword with a lower code rate. In this case, rate matching is performed on the first LDPC codeword, to obtain the second LDPC codeword with a lower code rate. In other words, the second code rate is lower than the first code rate.

It can be learned that the priority order of the check bits of the mother code provided in this application is used for rate matching of the LDPC codeword. On one hand, a puncturing position may be added to a puncturing pattern of an LDPC codeword with a low code rate, to obtain a higher code rate. On the other hand, the transmit end may fill a puncturing position in a puncturing pattern of an LDPC codeword with a high code rate, to obtain a lower code rate. In other words, a high code rate is compatible with a low code rate.

In the technical solutions provided in this application, priority orders of check bits of LDPC codes with different code lengths are different. For example, if a code length of an LDPC code is 1944, 1296, or 648, reliability of check bits of the LDPC code is different. Therefore, orders of priorities of puncturing the check bits of the LDPC codewords with different lengths during rate matching are also different. The following provides descriptions separately.

420: The transmit end sends the second LDPC codeword.

The transmit end performs rate matching on the LDPC codeword based on the priority order of puncturing check bits of the mother code of the LDPC code during rate matching, so that puncturing performance can be improved.

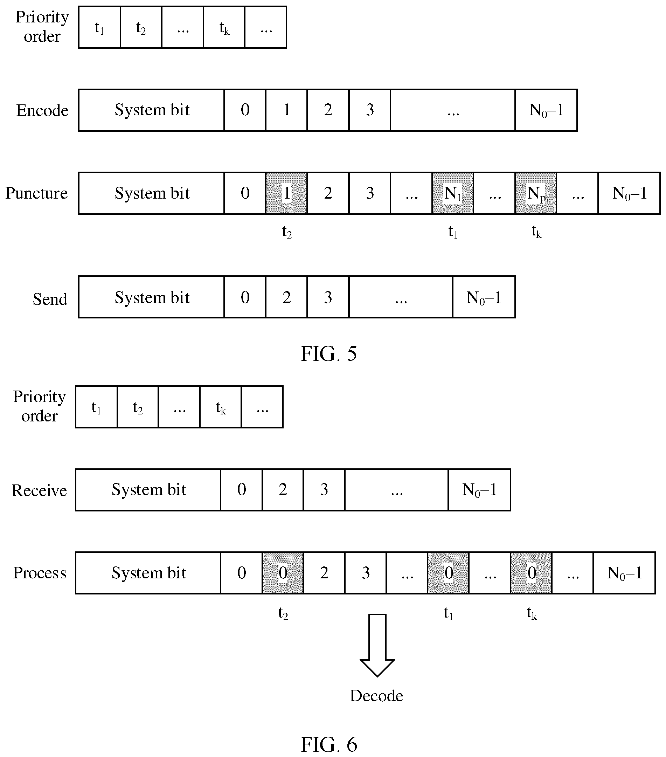

FIG. 5 is a schematic diagram of a rate matching process of an LDPC code according to this application. As shown in FIG. 5, it is assumed that a descending order of priorities of check bits of an LDPC code whose code length is N and whose code rate is R is $t_1, t_2, ..., t_k, ....$

A transmit end performs LDPC encoding on an information bit sequence (or system bits) to obtain an LDPC codeword, where the LDPC codeword includes k system bits and $N_0$ check bits.

According to the rate matching solution provided in this application, the transmit device performs, based on a priority order of check bits of a mother code of the LDPC code, rate matching on the LDPC codeword obtained through encoding. Specifically, it is assumed that a quantity of check bits that are determined by the transmit end based on a target code rate and that need to be punctured is $N_p$. In this case, the transmit end selects, based on a priority order of the check bits, first $N_p$ check bits from $t_1$, $t_2$, ..., $t_k$, ..., and records bit positions corresponding to the $N_p$ check bits. The transmit end punctures check bits at the $N_p$ bit positions of the LDPC codeword that is output after encoding, and then the transmit end sends a punctured LDPC codeword.

The following describes a schematic diagram of a decoding process at a receive end with reference to FIG. 6.

FIG. 6 is a schematic diagram of a decoding process at the receive end. The receive end receives information about a priority order of check bits of the mother code, where the priority order indicates sorting of priorities of puncturing the check bits of the mother code during rate matching. It should be understood that the priority order of the check bits of the mother code stored by the receive end is the same as the priority order of the check bits of the mother code stored by the transmit end, namely, $t_1¬$, $t_2$, ..., $t_k$, .... The receive end receives a channel receiving sequence, where the channel receiving sequence is corresponding to a system bit part and a check bit part. The check bit part has been punctured. The receive end pads, with zeros based on the priority order of the check bits of the mother code, corresponding positions in the check bit part of the channel receiving sequence, and then decodes an LLR sequence corresponding to the channel receiving sequence obtained through zero-padding. Specifically, the receive end may learn, based on the priority order and the quantity $N_p$ of to-be-punctured bits, bit positions corresponding to $N_p¬$ check bits with highest priorities, and the receive end pads the positions corresponding to the $N_p¬$ check bits with zeros. In other words, positions of the check bits punctured by the transmit end during rate matching is the positions that need to be padded with zeros by the receive end before decoding.

The following describes a principle of puncturing an LDPC code based on a priority order of check bits to improve decoding performance in this embodiment of this application.

The inventor of this application considers that, because a cycle exists in a Tanner graph, the cycle in the Tanner graph inevitably causes great interference to a decoding result. Iterative probabilistic decoding enables information to be transmitted between nodes. Therefore, if information about a specific bit position or some bit positions is incorrect, this error is transferred. This affects information about another bit position. If bits at these bit positions are preferentially punctured, puncturing performance is improved.

Optionally, in an example, sensitivity of a check bit of an LDPC code is first defined based on the following process:

First, a signal source is always an all-zero signal source. In a noiseless case, iterative calculation for a specific quantity of iterations is performed on an LDPC codeword on which rate matching has not been performed, and after iterative decoding is converged, an absolute value $|LLR|$ of a log-likelihood rate (likelihood rate, LLR) of the iterative decoding is used as a confidence feature, to determine sensitivity of a check bit. A smaller $|LLR|$ indicates that a bit position corresponding to $|LLR|$ is more sensitive.

It should be noted that, because the LDPC code is a linear code, and a sensitivity sorting of check bit positions determined by using different signal sources are similar, distribution characteristics of cycles and confidence to which different check bits belong are the same, and puncturing performance is basically the same. Therefore, in the technical solutions of this application, the signal source is always the all-zero signal source.

Check bits of LDPC codewords that are not punctured are sorted in ascending order of confidence, and a sorting relationship thereof is stored in a table T. The table T is a sorting table of sensitivity of the check bits.

The table T may be represented by using the following formula (1):

$$ T = \left( t_1, t_2, \cdots, t_{\frac{K}{R_0} - K} \right) \quad (1) $$

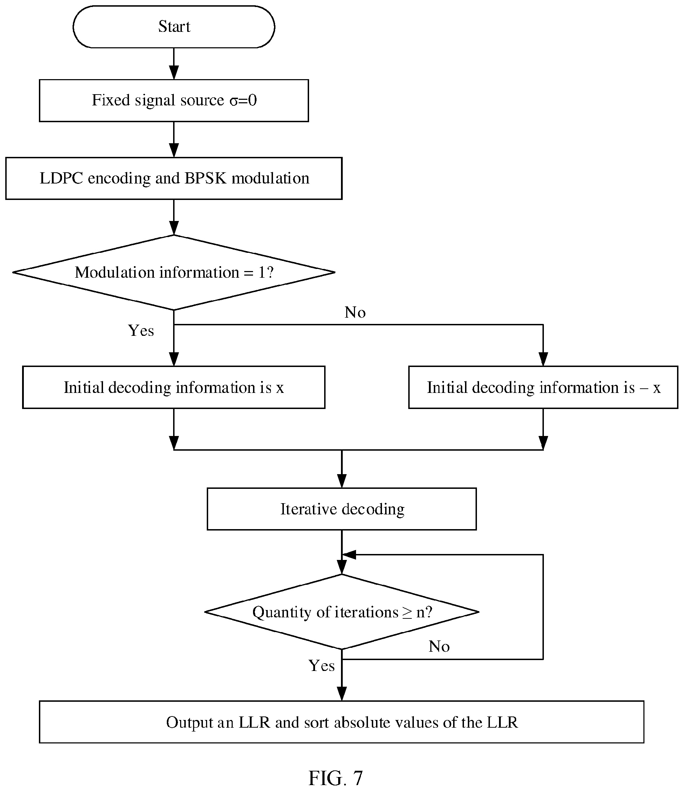

With reference to FIG. 7, the following describes a process of sorting of sensitivity of check bits.

FIG. 7 is a flowchart of establishing a sensitivity sorting of check bits according to this application. As shown in FIG. 7, in a noise-free environment, an all-zero signal source is fixed, LDPC code encoding with a corresponding code rate and code length is performed. Then, modulation such as binary phase shift keying (binary phase shift keying, BPSK) modulation is performed. Initial decoding information is set to a fixed value $\pm_x$, and then is sent to an iterative decoder for decoding. After a specific quantity of iterations (for example, n times), an LLR of check bits are output, and absolute values of the LLR are sorted, for example, sorted in ascending order.

Optionally, the iterative decoder may specifically be a log-SPA iterative decoder. SPA indicates a sum-product algorithm (sum-product algorithm), which is a type of LDPC decoding algorithm based on iterative decoding, and belongs to a soft-decision algorithm. If the log-SPA decoding algorithm is used, initial decoding information of an additive white Gaussian noise (additive white Gaussian noise, AWGN) channel is $y/\sigma^2$, where y is channel information, and $\sigma^2$ is a noise variance. When the noise variance is 0, the initial decoding information should be $\pm\infty$. If this is set directly in a computer program, data overflow will occur. Therefore, when a check information is solved, a function shown in formula (2) is used:

$$\varphi(x) = \log \frac{e^x + 1}{e^x - 1} \quad (2)$$

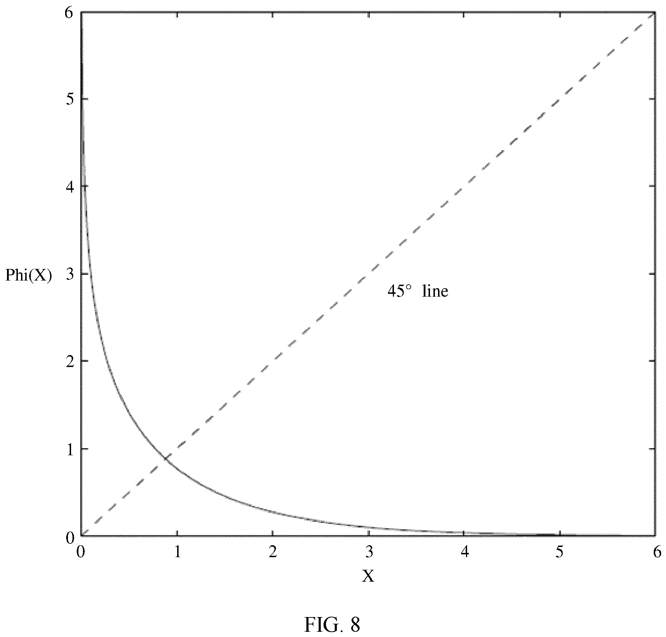

A function property of $\varphi(x)$ is shown in FIG. 8. FIG. 8 shows an image of the function $\varphi(x)$.

Optionally, in actual decoding, the decoding initial value x may be set to 3, 4, 5, or the like.

The following provides priority information of check bits of an LDPC code provided in this application if a code rate of the LDPC code is 1/2 and code lengths of the LDPC code are 1944, 1296, or 648.

(1) The code rate R = 1/2, and the code length L = 1944.

First, a check matrix of the LDPC code whose code rate is 1/2 and whose code length is 1944 is provided as follows:

$$
\begin{bmatrix}
57 & - & - & - & 50 & - & 11 & - & 50 & - & 79 & - & 1 & 0 & - & - & - & - & - & - & - & - & - & - \\
3 & - & 28 & - & 0 & - & - & - & 55 & 7 & - & - & - & 0 & 0 & - & - & - & - & - & - & - & - & - \\
30 & - & - & - & 24 & 37 & - & - & 56 & 14 & - & - & - & - & 0 & 0 & - & - & - & - & - & - & - & - \\
62 & 53 & - & - & 53 & - & - & 3 & 35 & - & - & - & - & - & - & 0 & 0 & - & - & - & - & - & - & - \\
40 & - & - & 20 & 66 & - & - & 22 & 28 & - & - & - & - & - & - & - & 0 & 0 & - & - & - & - & - & - \\
0 & - & - & - & 8 & - & 42 & - & 50 & - & - & 8 & - & - & - & - & - & 0 & 0 & - & - & - & - & - \\
69 & 79 & 79 & - & - & - & 56 & - & 52 & - & - & - & 0 & - & - & - & - & - & 0 & 0 & - & - & - & - \\
65 & - & - & - & 38 & 42 & - & - & 72 & - & 27 & - & - & - & - & - & - & - & - & 0 & 0 & - & - & - \\
64 & - & - & - & 14 & 56 & - & - & 30 & - & - & 32 & - & - & - & - & - & - & - & - & 0 & 0 & - & - \\
- & 45 & - & 70 & 0 & - & - & - & 77 & 9 & - & - & - & - & - & - & - & - & - & - & - & 0 & 0 & - \\
2 & 56 & - & 57 & 35 & - & - & - & - & - & 12 & - & - & - & - & - & - & - & - & - & - & - & 0 & 0 \\
24 & - & 61 & - & 60 & - & - & 27 & 51 & - & - & 16 & 1 & - & - & - & - & - & - & - & - & - & - & 0
\end{bmatrix}
$$

As shown above, a size of the check matrix is 12 × 24, and each element in the check matrix indicates a square matrix of z = 1944/24 = 81-order. "-" indicates an all-zero matrix of 81 × 81. Each element i in the check matrix indicates a circulant permutation matrix of 81 × 81, and i indicates a cyclic shift value. For example, i = 0 indicates an identity matrix whose size is 81 × 81, and i = 1 indicates a cyclic shift matrix shown in the following formula (3):

$$
\begin{bmatrix}
0 & 1 & 0 & \dots & 0 \\
0 & 0 & 1 & \dots & 0 \\
\vdots & \vdots & \vdots & \ddots & \vdots \\
0 & 0 & 0 & \cdots & 1 \\
1 & 0 & 0 & \cdots & 0
\end{bmatrix} \quad (3)
$$

According to the method for sorting sensitivity of check bits provided in this application, a priority order of puncturing, during rate matching, columns corresponding to check bits in the check matrix of the LDPC code whose code rate is 1/2 and whose code length is 1944 is sorted in descending order. The priority order is as the following sorting 1:

Sorting 1: 19, 20, 18, 21, 17, 22, 16, 23, 15, 24, 14, and 13.

Each element a in the foregoing priority order indicates an $a^{th}$ column of the check matrix.

It can be learned from the foregoing descriptions of the check matrix that each column of a mother matrix of the check matrix is corresponding to z check bits of a mother code. It can be learned that, in the foregoing check matrix of the LDPC code whose code rate is 1/2 and whose code length is 1944, each column corresponding to a check bit is corresponding to z check bits of a mother code, and z = 1944/24 = 81.

Specifically, each column in a 13th column to a 24th column of the check matrix of the LDPC code whose code rate is 1/2 and whose code length is 1944 is corresponding to 81 check bits.

In a rate matching process, a check bit corresponding to a column with a high priority is first considered to be punctured. The sorting 1 is used as an example. If a quantity of check bits that need to be punctured during rate matching is exactly 81, 81 check bits corresponding to the 19th column of the check matrix are punctured. If a quantity of check bits that need to be punctured is 81 × 2, 81 check bits corresponding to each of the 19th column and the 20th column of the check matrix are punctured. By analogy, a required quantity of check bits are punctured in descending order of priorities of the columns shown in the sorting 1.

Further, in this application, priorities of puncturing check bits that belong to a same column of the check matrix are the same.

The sorting 1 is used as an example. The 19th column is corresponding to 81 check bits, and the 81 check bits have a same puncturing priority. For another example, the 20th column is corresponding to 81 check bits, and the 81 check bits corresponding to the 20th column have a same puncturing priority. The same principle applies to other columns in the sorting 1.

It is assumed that a quantity of to-be-punctured bits required for rate matching is L. In a possible case, if L < z, a transmit end punctures L check bits in z check bits corresponding to a column with a highest priority in the priority sorting. The L check bits are any L of the z check bits corresponding to the column with the highest priority. In other words, the L check bits may be randomly selected from the z check bits corresponding to the column with the highest priority.

In another possible case, if L=mz, it indicates that a required quantity of to-be-punctured bits is equal to a quantity of check bits corresponding to a column corresponding to a check bit in the check matrix. In this case, the transmit end punctures z check bits corresponding to a column with a highest priority.

The following uses the LDPC code whose code length is 1/2 and whose code length is 1944 (that is, z = 81) as an example to describe selection of a to-be-puncturing position of a check bit. If the LDPC code whose code length is 1/2 and whose code length is 1296 (that is, z = 54) or the LDPC code whose code length is 1/2 and whose code length is 648 (that is, z = 27) is used, a same criterion is used for selecting a to-be-puncturing position of a check bit.

The sorting 1 is used as an example. For example, if a quantity of to-be-punctured bits that is determined based on a target code rate is 81, 81 check bits corresponding to the 19th column are preferentially punctured. For another example, if a quantity of to-be-punctured bits is 81 × 2, the transmit end punctures 81 check bits corresponding to the 19th column and 81 check bits corresponding to the 20th column.

In another possible case, if L > z, the transmit end punctures L check bits in tz check bits corresponding to first t columns whose priorities are in descending order, where the L check bits include z(t-1) check bits corresponding to first (t-1) columns in the t columns and p check bits in a tth column, the p check bits are any p check bits in z check bits corresponding to the tth column, both t and p are positive numbers, and $p \le z$.

The sorting 1 is used as an example. For example, if a quantity of to-be-punctured bits is 100, and 100 = 81 × 1 + 19, the transmit end punctures 81 check bits corresponding to the 19th column, and punctures 19 check bits in 81 check bits corresponding to the 20th column. The 19 check bits are randomly selected from the 81 check bits corresponding to the 20th column.

For another example, if a quantity of to-be-punctured bits is 190, and 100 = 81 × 2 + 28, the transmit end punctures 81 check bits corresponding to the 19th column and 81 check bits corresponding to the 20th column, and punctures any 28 check bits in 81 check bits corresponding to the 18th column.

It should be noted that a column index in the sorting 1 is based on a column index of the check matrix and starts from 1. To be specific, if a column index of a check matrix of a mother code whose code length is 1944 and whose code rate is 1/2 is represented by using 1 to 24, an index of a column corresponding to a check bit in the check matrix ranges from 13 to 24.

In another possible representation manner, a column index of a check matrix of a mother code may start from 0, and the column index of the check matrix ranges from 0 to 23. An index of a column corresponding to a check bit in the check matrix should range from 12 to 23.

In this representation, a priority order of puncturing, during rate matching, columns corresponding to check bits in the check matrix of the LDPC code whose code rate is 1/2 and whose code length is 1944 is sorted in descending order of priorities. The priority order is as the following sorting 2:

Sorting 2: 18, 19, 17, 20, 16, 21, 15, 22, 14, 23, 13, and 12.

It should be understood that the sorting 1 and the sorting 2 are equivalent, both indicate priorities of puncturing, during rate matching, columns corresponding to check bits in the check matrix of the LDPC code whose code rate is 1/2 and whose code length is 1944, and a difference only lies in different column indexes of the check matrix.

It may be understood that a check bit at a bit position with low confidence is preferentially punctured, because the check bit provides less valid information for another system bit. In addition, puncturing the check bit can further ensure recoverability of a system bit, especially when a large quantity of bits need to be punctured.

Absolute values of an LLR of check bits in the check matrix corresponding to the LDPC code whose code rate is 1/2 and whose code length is 1944 and a reliability sorting of the check bits may be shown in a table 1.

**Table 1**

| Reliability sorting | 19 (2) | 20 (2) | 18 (2) | 21 (2) | 17 (2) | 22 (2) |
|---|---|---|---|---|---|---|
| $|LLR|$ | 26.9747 | 27.1948 | 27.3161 | 27.9524 | 28.1107 | 29.1414 |
| Reliability sorting | 16 (2) | 23 (2) | 15 (2) | 24 (2) | 14 (2) | 13 (3) |
| $|LLR|$ | 29.2333 | 30.6309 | 30.6696 | 32.3636 | 32.5114 | 32.5925 |

In "reliability sorting" in the first row of the table 1, each element a (b) indicates an $a^{th}$ column of the check matrix, and a column weight of the $a^{th}$ column is b. $|LLR|$ corresponding to the $a^{th}$ column indicates $|LLR|$ of a check bit of the $a^{th}$ column.

In the table 1, in the reliability sorting, the column index range of the check matrix is 1 to 24.

In addition, it may be noted that columns related to the sorting in the table 1 include a $13^{th}$ column to a $24^{th}$ column of the check matrix. This is because the $13^{th}$ column to the $24^{th}$ column of the check matrix whose code rate is 1/2 and whose code length is 1944 are corresponding to a check part of the check matrix. Codeword bits corresponding to the part of columns are all check bits generated through encoding.

A table 2 shows a comparison between a puncturing solution based on a confidence criterion provided in this application and a puncturing solution in the 802.11ac standard.

**Table 2**

| | Puncturing two columns | Puncturing four columns | Puncturing six columns | Puncturing eight columns | Puncturing nine columns |
|---|---|---|---|---|---|
| Puncturing solution based on a confidence criterion | 19 and 20 | 19, 20, 18, and 21 | 19, 20, 18, 21, 17, and 22 | 19, 20, 18, 21, 17, 22, 16, and 23 | 19, 20, 18, 21, 17, 22, 16, 23, and 15 |
| Puncturing solution in 802.11ac | 24 and 23 | 24, 23, 22, and 21 | 24, 23, 22, 21, 20, and 19 | 24, 23, 22, 21, 20, 19, 18, and 17 | 24, 23, 22, 21, 20, 19, 18, 17, and 16 |

It can be learned that the puncturing priorities in the 802.11ac standard are in descending order from back to front, to be specific, from the $24^{th}$ column to the $16^{th}$ column. When a column of the check matrix is used as a puncturing unit, the puncturing solution of puncturing two columns, four columns, six columns, eight columns, and nine columns of LDPC codewords based on the confidence criterion provided in this application is different from the puncturing solution in the 802.11ac standard.

In addition, it can be further found from the table 2 that, in the technical solutions of this application, for an LDPC code with a specific code length, a puncturing position set of check bits of an LDPC code with a high code rate includes a puncturing position set of check bits of an LDPC code with a low code rate. In other words, the puncturing position set of the check bits of the LDPC code with the low code rate is a proper subset of the puncturing position set of the check bits of the LDPC code with the high code rate.

For example, if a quantity of to-be-punctured bits is two columns, a puncturing position set of the LDPC code is represented by using a column corresponding to a check bit in the check matrix, and a set of indexes of punctured columns is {19, 20}.

If a quantity of to-be-punctured bits is four columns, a puncturing position set of the LDPC code is represented by using a column corresponding to a check bit in the check matrix, and a set of indexes of punctured columns is {19, 20, 18, 21}.

If a quantity of to-be-punctured bits is six columns, a puncturing position set of the LDPC code is represented by using a column corresponding to a check bit in the check matrix, and a set of indexes of punctured columns is {19, 20, 18, 21, 17, 22}.

It may be learned from a puncturing principle that a larger quantity of to-be-punctured bits indicates a higher LDPC code rate. Therefore, a puncturing position set of an LDPC code with a low code rate is a proper subset of a puncturing position set of an LDPC code with a high code rate. In other words, in the puncturing solution in this application, a high code rate is compatible with a low code rate. In other words, a puncturing position set of an LDPC code with a higher code rate can be obtained by adding a new puncturing position to a puncturing position set of an LDPC code with a low code rate.

(2) The code rate R = 1/2, and the code length L = 1296.

The following first provides a check matrix of the LDPC code whose code rate is 1/2 and whose code length is 1296 is provided as follows:

$$
\begin{bmatrix}
40 & - & - & - & 22 & - & 49 & 23 & 43 & - & - & - & 1 & 0 & - & - & - & - & - & - & - & - & - & - \\
50 & 1 & - & - & 48 & 35 & - & - & 13 & - & 30 & - & - & 0 & 0 & - & - & - & - & - & - & - & - & - \\
39 & 50 & - & - & 4 & - & 2 & - & - & - & - & 49 & - & - & 0 & 0 & - & - & - & - & - & - & - & - \\
33 & - & - & 38 & 37 & - & - & 4 & 1 & - & - & - & - & - & - & 0 & 0 & - & - & - & - & - & - & - \\
45 & - & - & - & 0 & 22 & - & - & 20 & 42 & - & - & - & - & - & - & 0 & 0 & - & - & - & - & - & - \\
51 & - & - & 48 & 35 & - & - & - & 44 & - & 18 & - & - & - & - & - & - & 0 & 0 & - & - & - & - & - \\
47 & 11 & - & - & - & 17 & - & - & 51 & - & - & - & 0 & - & - & - & - & - & 0 & 0 & - & - & - & - \\
5 & - & 25 & - & 6 & - & 45 & - & 13 & 40 & - & - & - & - & - & - & - & - & - & 0 & 0 & - & - & - \\
33 & - & - & 34 & 24 & - & - & - & 23 & - & - & 46 & - & - & - & - & - & - & - & - & 0 & 0 & - & - \\
1 & - & 27 & - & 1 & - & - & - & 38 & - & 44 & - & - & - & - & - & - & - & - & - & - & 0 & 0 & - \\
- & 18 & - & - & 23 & - & - & 8 & 0 & 35 & - & - & - & - & - & - & - & - & - & - & - & - & 0 & 0 \\
49 & - & 17 & - & 30 & - & - & - & 34 & - & - & 19 & 1 & - & - & - & - & - & - & - & - & - & - & 0
\end{bmatrix}
$$

As shown above, a size of the check matrix is 12 × 24, and each element in the check matrix indicates a square matrix of z = 1296/24 = 54-order. "-" indicates an all-zero matrix of 54 × 54. Each element i in the check matrix indicates a circulant permutation matrix of 54 × 54, and i indicates a cyclic shift value. For example, i = 0 indicates an identity matrix whose size is 54 × 54, and i = 1 indicates a cyclic shift matrix whose cyclic shift value is 1.

According to the method for sorting sensitivity of check bits provided in this application, a priority order of puncturing, during rate matching, columns corresponding to check bits in the check matrix of the LDPC code whose code rate is 1/2 and whose code length is 1296 is sorted in descending order as the following sorting 3:

Sorting 3: 20, 15, 21, 14, 19, 23, 16, 24, 18, 22, 17, and 13.

Each element a in the foregoing priority order indicates an $a^{th}$ column of the check matrix.

Similarly, the sorting 3 is represented based on a column index range, 1 to 24, of the check matrix. If a column index of the check matrix starts from 0, a priority order of puncturing, during rate matching, columns corresponding to check bits in the check matrix of the LDPC code whose code rate is 1/2 and whose code length is 1296 is sorted in descending order as the following sorting 4:

Sorting 4: 19, 14, 20, 13, 18, 22, 15, 23, 17, 21, 16, and 12.

Absolute values of an LLR of check bits in the check matrix corresponding to the LDPC code whose code rate is 1/2 and whose code length is 1944 and a reliability sorting of the check bits may be shown in a table 3.

**Table 3**

| Reliability sorting | 20 (2) | 15 (2) | 21 (2) | 14 (2) | 19 (2) | 23 (2) |
|---|---|---|---|---|---|---|
| $\|LLR\|$ | 1.6921 | 1.6992 | 1.7496 | 1.7627 | 1.7793 | 1.7805 |
| Reliability sorting | 16 (2) | 24 (2) | 18 (2) | 22 (2) | 17 (2) | 13 (3) |
| $\|LLR\|$ | 1.7834 | 1.7985 | 1.8260 | 1.8287 | 1.8295 | 2.0309 |

In "reliability sorting" in the first row of the table 3, each element a (b) indicates an $a^{th}$ column of the check matrix, and a column weight of the $a^{th}$ column is b. $\|LLR\|$ corresponding to the $a^{th}$ column indicates $\|LLR\|$ of a check bit of the $a^{th}$ column.

Similar to the foregoing LDPC code whose code length is 1944, in this application, only reliability of check bits is sorted. Therefore, the table 3 shows a priority sorting of check bits in a 13th column to a 24th column of the check matrix of the LDPC code whose code length is 1/2 and whose code length is 1296.

In the table 3, in the reliability sorting, the column index range of the check matrix is 1 to 24.

In addition, each column of the check matrix of the LDPC code whose code rate is 1/2 and whose code length is 1296 is corresponding to 54 check bits of the mother code. Priorities of puncturing check bits that belong to a same column of the check matrix are the same. For example, the 20th column with a highest priority is corresponding to 54 check bits of the mother code, and priorities of the 54 check bits are the same. If the transmit end needs to puncture t check bits in the 20th column, and t < 54, the t check bits may be randomly selected from 54 check bits in the 20th column. Other columns in the table 3 are similar, and details are not described again.

(3) The code rate R = 1/2, and the code length L = 648.

The following first provides a check matrix of the LDPC code whose code rate is 1/2 and whose code length is 648 is provided as follows:

$$
\begin{bmatrix}
0 & - & - & - & 0 & 0 & - & - & 0 & - & - & 0 & 1 & 0 & - & - & - & - & - & - & - & - & - & - \\
22 & 0 & - & - & 17 & - & 0 & 0 & 12 & - & - & - & - & 0 & 0 & - & - & - & - & - & - & - & - & - \\
6 & - & 0 & - & 10 & - & - & - & 24 & - & 0 & - & - & - & 0 & 0 & - & - & - & - & - & - & - & - \\
2 & - & - & 0 & 20 & - & - & - & 25 & 0 & - & - & - & - & - & 0 & 0 & - & - & - & - & - & - & - \\
23 & - & - & - & 3 & - & - & - & 0 & - & 9 & 11 & - & - & - & - & 0 & 0 & - & - & - & - & - & - \\
24 & - & 23 & 1 & 17 & - & 3 & - & 10 & - & - & - & - & - & - & - & - & 0 & 0 & - & - & - & - & - \\
25 & - & - & - & 8 & - & - & - & 7 & 18 & - & - & 0 & - & - & - & - & - & 0 & 0 & - & - & - & - \\
13 & 24 & - & - & 0 & - & 8 & - & 6 & - & - & - & - & - & - & - & - & - & - & 0 & 0 & - & - & - \\
7 & 20 & - & 16 & 22 & 10 & - & - & 23 & - & - & - & - & - & - & - & - & - & - & - & 0 & 0 & - & - \\
11 & - & - & - & 19 & - & - & - & 13 & - & 3 & 17 & - & - & - & - & - & - & - & - & - & 0 & 0 & - \\
25 & - & 8 & - & 23 & 18 & - & 14 & 9 & - & - & - & - & - & - & - & - & - & - & - & - & - & 0 & 0 \\
3 & - & - & - & 16 & - & - & 2 & 25 & 5 & - & - & 1 & - & - & - & - & - & - & - & - & - & - & 0
\end{bmatrix}
$$

As shown above, a size of the check matrix is 12 × 24, and each element in the check matrix indicates a square matrix of z = 648/24 = 27-order. "-" indicates an all-zero matrix of 27 × 27. Each element i in the check matrix indicates a circulant permutation matrix of 27 × 27, and i indicates a cyclic shift value. For example, i = 0 indicates an identity matrix whose size is 27 × 27, and i = 1 indicates a cyclic shift matrix whose cyclic shift value is 1.

According to the method for sorting sensitivity of check bits provided in this application, a priority order of puncturing, during rate matching, columns corresponding to check bits in the check matrix of the LDPC code whose code rate is 1/2 and whose code length is 648 is sorted in descending order as the following sorting 5:

Sorting 5: 21, 15, 22, 23, 18, 19, 14, 24, 20, 16, 17, and 13.

Each element a in the foregoing priority order indicates an ath column of the check matrix.

Similarly, the sorting 5 is represented based on a column index range, 1 to 24, of the check matrix. If a column index of the check matrix starts from 0, a priority order of puncturing, during rate matching, columns corresponding to check bits in the check matrix of the LDPC code whose code rate is 1/2 and whose code length is 1296 is sorted in descending order as the following sorting 6:

Sorting 6: 20, 14, 21, 22, 17, 18, 13, 23, 19, 15, 16, and 12.

Absolute values of an LLR of check bits in the check matrix corresponding to the LDPC code whose code rate is 1/2 and whose code length is 648 and a reliability sorting of the check bits may be shown in a table 4.

**Table 4**

| Reliability sorting | 21 (2) | 15 (2) | 22 (2) | 23 (2) | 18 (2) | 19 (2) |
|---|---|---|---|---|---|---|
| $|LLR|$ | 2.0989 | 2.1302 | 2.1389 | 2.1471 | 2.1630 | 2.1634 |
| Reliability sorting | 14 (2) | 24 (2) | 20 (2) | 16 (2) | 17 (2) | 13 (3) |
| $|LLR|$ | 2.1816 | 2.1893 | 2.2364 | 2.2568 | 2.2851 | 2.6900 |

In "reliability sorting" in the first row of the table 4, each element a (b) indicates an $a^{th}$ column of the check matrix, and a column weight of the $a^{th}$ column is b. $|LLR|$ corresponding to the $a^{th}$ column indicates $|LLR|$ of a check bit of the $a^{th}$ column.

It may be understood that, in this application, only reliability of check bits is sorted. Therefore, the table 4 shows a priority sorting of check bits in a $13^{th}$ column to a $24^{th}$ column of the check matrix of the LDPC code whose code length is 1/2 and whose code length is 1296.

Each column of the check matrix of the LDPC code whose code rate is 1/2 and whose code length is 648 is corresponding to 27 check bits of the mother code. Priorities of puncturing check bits that belong to a same column of the check matrix are the same. For example, the $21^{th}$ column with a highest priority is corresponding to 27 check bits of the mother code, and priorities of the 27 check bits are the same. If the transmit end needs to puncture t check bits in the $21^{th}$ column, and t < 27, the t check bits may be randomly selected from 27 check bits in the $21^{th}$ column. Other columns in the table 4 are similar, and details are not described again.

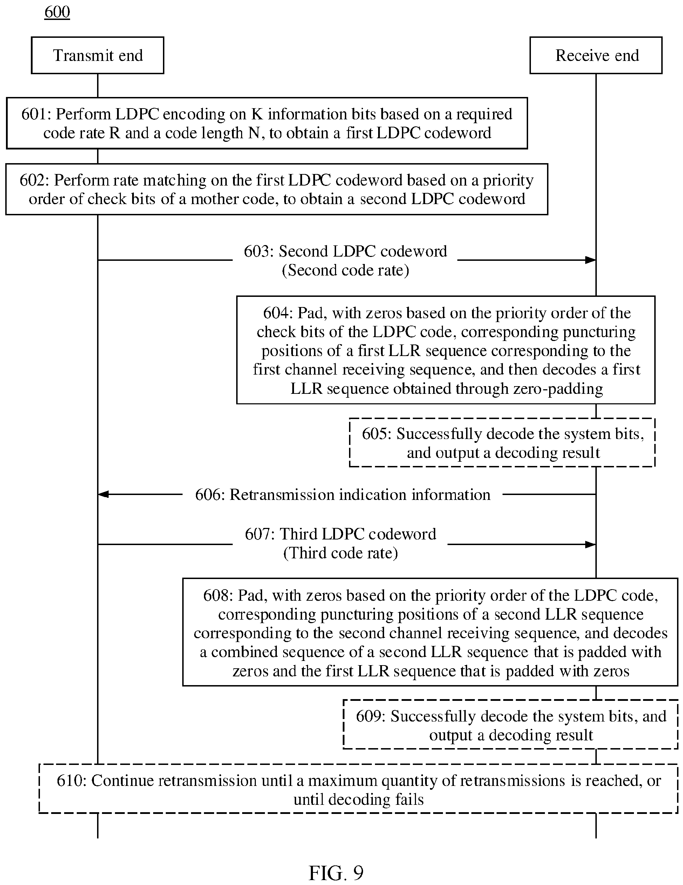

The foregoing describes in detail the LDPC code rate matching method provided in this application. The following describes application of the technical solutions of this application in an IR HARQ scenario with reference to FIG. 9. In the IR-HARQ scenario, as a quantity of retransmissions increases, more incremental redundant bits may be obtained by puncturing more check bits, so that a code rate continuously decreases. This can increase a probability of successful decoding at a receive end, and improve decoding performance.

FIG. 9 is an application example of an LDPC code rate matching method according to this application.

Optionally, an operation or processing performed by a receive end in the flowchart shown in FIG. 9 may also be performed by a chip, a circuit system, or the like disposed in a receive device. The circuit system may be, for example, an integrated circuit or a logic circuit. The chip may be a system on chip (system on a chip, SoC) chip, a baseband modem (modem) chip, or the like. This is not limited in this specification. The following uses the receive device as an example for description.

The receive end may be a terminal device or a network device. It should be understood that the receive end in this embodiment of this application is also a decoding device. For example, in uplink transmission, a transmit end is a terminal device, and the receive end is a network device. In downlink transmission, the transmit end is a network device, and the receive end is a terminal device.

601: The transmit end performs LDPC encoding on K information bits based on a required code rate R and a code length N, to obtain a first LDPC codeword. A code rate of the first LDPC codeword is R, a code length is N, where K and N are all integers.

It may be understood that the code rate R of the first LDPC codeword may be used as a basic code rate. For example, R may be 1/2. Based on this code rate, A higher code rate, for example, 2/3, 3/4, or 5/6 can be obtained by puncturing an LDPC code.

LDPC encoding is performed on an information bit sequence based on the foregoing provided check matrices whose code rates are 1/2 and whose code lengths are 1944, 1296, and 648, to obtain the first LDPC codeword whose code rate is 1/2 and whose code length is N. A value of N may be 1944, 1296, or 648, depending on a check matrix used during encoding.

For example, if the transmit end uses a check matrix corresponding to an LDPC code whose code rate is 1/2 and whose code length is 1944, the length of the first LDPC codeword obtained through encoding is 1944.

For another example, if the transmit end uses a check matrix corresponding to an LDPC code whose code rate is 1/2 and whose code length is 1296, the length of the first LDPC codeword obtained through encoding is 1296.

For another example, if the transmit end uses a check matrix corresponding to an LDPC code whose code rate is 1/2 and whose code length is 648, the length of the first LDPC codeword obtained through encoding is 648.

The following uses the code length N = 1944 as an example for description.

602: The transmit end performs rate matching on the first LDPC codeword based on a priority order of check bits of a mother code, to obtain a second LDPC codeword.

The transmit end punctures the check bits of the first LDPC codeword based on a required code rate (or a target code rate) and based on the priority order of the check bits of the mother code whose code rate is 1/2 and whose code length N is 1944, to obtain the second LDPC codeword with a second code rate.

In other words, the second LDPC codeword is a codeword obtained by puncturing the first LDPC codeword. Therefore, a code rate (that is, the second code rate) of the second LDPC codeword is greater than a first code rate.

In this embodiment, the LDPC codeword whose code rate is 1/2 is used as the basic codeword, and the basic codeword is punctured, to obtain a codeword with a higher code rate (that is, the second code rate).

603: The transmit end sends the second LDPC codeword.

The receive end receives a first channel receiving sequence from the transmit end.

604: The receive end pads, with zeros based on the priority order of the check bits of the LDPC code whose code rate is 1/2 and whose code length is N, corresponding puncturing positions of a first LLR sequence corresponding to the first channel receiving sequence, and then decodes a first LLR sequence obtained through zero-padding.

As described in FIG. 6 above, before performing decoding, the receive end first pads, with zeros, bit positions corresponding to check bits punctured by the transmit end, and then performs decoding.

Because both the receive end and the transmit end store priority information of check bits of LDPC codes that have different code lengths and whose code rates are 1/2, the receive end may learn of positions of punctured check bits based on a current code rate and a current code length. Therefore, the receive end pads, with zeros, the positions of these punctured check bits before performing decoding.

The receive end decodes a first LLR sequence that is padded with zeros. In a possible case, the receive end successfully decodes all system bits of the second LDPC codeword. In this case, the receive end performs step 605.

605: When the receive end successfully decodes all the system bits, the receive end outputs a decoding result.

After step 605, communication of a next data packet is performed.

In another possible case, if the receive end fails to decode all system bits, the receive end sends retransmission indication information to the transmit end, to request the transmit end to perform retransmission, as described in the following steps 606 to 608.

606: The receive end sends the retransmission indication information to the transmit end.

The retransmission indication information indicates the transmit end to retransmit the LDPC codeword. Optionally, the retransmission indication information may further indicate a part that is not correctly received. For example, the part that is not correctly received may be a codeword (codeword) or a media access control protocol data unit (media access control protocol data unit, MPDU) MPDU, depending on a specific configuration.

The transmit end receives the retransmission indication information from the receive end.

It should be noted that, if the receive end does not correctly decode the system bits of the LDPC codeword, a mechanism in which the transmit end performs retransmission may have a plurality of specific implementations. A manner in which the receive end sends the retransmission indication information to the transmit end to request the transmit end to perform retransmission in FIG. 9 is merely used as an example. This is not limited in this specification.

607: The transmit end sends a third LDPC codeword with a third code rate. A puncturing position set of check bits of the third LDPC codeword is a subset of a puncturing position set of check bits of the second LDPC codeword.

It may be understood that the second LDPC code with the second code rate is not successfully decoded by the receive end. In a retransmission case, a code rate is usually reduced, to increase a probability of successful decoding by the receive end. Therefore, in an example, a code rate (namely, the third code rate) of the third LDPC code is lower than the second code rate.

In addition, in an IR-HARQ scenario, a puncturing pattern corresponding to a high code rate is compatible with a puncturing pattern corresponding to a low code rate. In other words, the puncturing pattern of the high code rate includes the puncturing pattern of the low code rate. In other words, a set of puncturing positions of the low code rate includes a set of puncturing positions of the high code rate.

Optionally, in an example, the third LDPC codeword may be obtained by performing LDPC encoding on t check bits based on a required third code rate and a required code length N. The t check bits are the check bits that are punctured during rate matching process described in step 602. t and k are integers.

In other words, the transmit end first sends the second LDPC codeword with a higher code rate. If the receive end does not correctly decode all the system bits of the second LDPC codeword, the transmit end may send t more punctured check bits.

In an embodiment, during retransmission, the transmit end may send only punctured check bits. For example, the t check bits may be first t check bits with highest reliability in all the punctured check bits of the first LDPC codeword.

For example, a priority order of puncturing check bits of an LDPC code whose code length is L is shown as follows: $\{n_1, n_2, ..., n_k, ...\}$, where $n_i$ indicates a position of a punctured check bit, and both $n_i$ and k are integers.

It should be understood that a higher priority of puncturing a check bit during rate matching indicates lower reliability of the check bit. Therefore, the t check bits are check bits at t positions from back to front in $\{n_1, n_2, ..., n_k, ...\}$.

If $\{n_1, n_2, ..., n_k, ...\}$ includes m elements in total, a value range of t may be (1, m), where m is an integer.

In another embodiment, during retransmission, the transmit end may send a part of punctured check bits and system bits. This is not limited in this specification.

The receive end receives a second channel receiving sequence from the transmit end.

608: The receive end pads, with zeros based on the priority order of the check bits of the LDPC code, corresponding puncturing positions of a second LLR sequence corresponding to the second channel receiving sequence, and decodes a combined sequence of a second LLR sequence that is padded with zeros and the first LLR sequence that is padded with zeros.

The combined sequence is obtained by combining the second LLR sequence that is padded with zeros and the first LLR sequence that is padded with zeros. Specifically, the second LLR sequence that is padded with zeros and the first LLR sequence that is padded with zeros are combined bitwise. LLR values at a same bit position in the second LLR sequence that is padded with zeros and the first LLR sequence that is padded with zeros are combined, and LLR values at different bit positions are retained.

For example, a length of the first LLR sequence that is padded with zeros is 6, index positions are 1, 2, 3, 4, and 5, and corresponding LLR values are LLR11, LLR12, LLR13, LLR14, and LLR15. A length of the second LLR sequence that is padded with zeros is 6, index positions are 3, 4, 5, 6, and 7, and corresponding LLR values are LLR23, LLR24, LLR25, LLR26, and LLR27. Therefore, the combined sequence is {LLR11, LLR12, LLR13 + LLR23, LLR14 + LLR24, LLR15 + LLR25, LLR26, LLR27}, where addition of the LLR values is binary addition.

In this embodiment of this application, that the receive end performs combination based on the LLR sequences is merely used as an example. A person skilled in the art can easily figure out other equivalent processing. For example, the receive end may alternatively combine soft information obtained through demodulation. This may specifically depend on a decoding mechanism of the receive end.

In a case, when the receive end successfully obtains all the system bits through decoding based on the combined sequence, the receive end outputs the decoding result, as shown in step 609.

In another case, the receive end still fails to obtain, based on the combination sequence, the system bits through decoding. The receive end may request the transmit end to perform next retransmission, until the receive end successfully obtains the system bits through decoding, or until a specified maximum quantity of retransmissions is reached, then the receive end determines that decoding fails, as described in step 610.

Specifically, when the receive end fails to restore the system bits, the transmit end may send punctured check bits in descending order of reliability. For example, the transmit end first sends first $t_1$ punctured check bits with highest reliability, namely, check bits at $t_1$ positions from back to front in $\{n_1, n_2, ..., n_k, ...\}$. If the receive end fails to perform decoding, the receive end further sends $t_2$ punctured check bits with second highest reliability, namely, check bits at $t_2$ positions, starting from a $(t_1-1)^{th}$ position, from back to front in $\{n_1, n_2, ..., n_k, ...\}$. The rest may be deduced by analogy until all punctured check bits are sent. It may be understood that, in this process, a code rate continuously decreases. When the transmit end retransmits all punctured check bits, if the receive end still cannot correctly decode the system bits, it indicates that the data packet fails to be transmitted.

It can be learned from the foregoing retransmission process that a code rate of an $1^{th}$ retransmission may meet the following relationship:

$$R_c = \frac{k}{n} \le R_e = \frac{k}{n\text{-}n_{cp} + \sum\limits_{i=0}^{l} t_i} \le R_c^{'} = \frac{k}{n\text{-}n_{cp}} \quad (4)$$

In formula (4), $R_c^{'}$ is a code rate of the LDPC codeword sent by the transmit end for the first time, and a redundancy amount added for the first time is t0 = 0, k indicates the quantity of system bits, $n_{cp}$ indicates a total quantity of punctured check bits, and n indicates the length of the mother code of the LDPC code. It should be understood that the mother code in this embodiment of this application indicates an LDPC code on which rate matching is not performed (for example, not punctured).

The foregoing describes in detail the rate matching process of the LDPC code and the decoding process of the receive end that are provided in this application. The following describes application of the method in IR-HARQ by using an example.

In an example, the transmit end and the receive end store information about a priority order of puncturing check bits in a rate matching process.

It is assumed that a descending order of priorities of the check bits is $\{n_1, n_2, ..., n_T, ...\}$, and T is an integer.

Initial IR-HARQ transmission is performed, and the transmit end may determine, based on a code rate required for the initial IR-HARQ transmission, a quantity L of check bits that need to be punctured. The transmit end selects, based on the quantity L of check bits that need to be punctured and the priority order of the check bits, first L check bits with highest priorities, and records respective positions of the L check bits. After completing LDPC encoding, the transmit end punctures the L check bits of an output LDPC codeword and then sends the LDPC codeword.

For ease of understanding, it is assumed that the L check bits punctured in the initial transmission are $\{n_1, n_2, ..., n_T\}$, where the sorting in descending order of priorities.

In the initial transmission, an LDPC code with a high code rate is obtained through puncturing, for example, the code rate is 5/6.

For the initial IR-HARQ transmission, the receive end determines, based on a currently used code length, the code rate, and the corresponding quantity L of to-be-punctured bits of the LDPC code and based on the priority order of the check bits, the respective positions (namely, indexes) of the L check bits with highest priorities. After padding the positions corresponding to the L check bits with zeros, the receive end decodes the LDPC code.

If the initial IR-HARQ transmission fails, in other words, if the receive end fails to decode all the system bits, retransmission in an IR-HARQ mechanism is performed.

If IR-HARQ retransmission is performed, the transmit end may determine, based on a code rate required for retransmission or based on a quantity of channel resources allocated for retransmission, a quantity P of bits that need to be punctured for retransmission, where P is an integer.

It may be understood that, to improve a decoding success rate of the receive end, the code rate is usually reduced for retransmission. Therefore, the code rate used for retransmission is usually lower than a code rate used for initial transmission. In other words, the quantity P of bits that need to be punctured in retransmission is less than a quantity N of bits that need to be punctured in the initial transmission.

For ease of description, it is assumed that a code rate used in first retransmission is $R_1$.

When the first retransmission is performed, the transmit end may send $t_1$ check bits with lowest priorities in the L check bits punctured in the initial transmission, where $t_1$ is an integer.

Specifically, the transmit end may select the $t_1$ check bits from $\{n_1, n_2, ..., n_T\}$ in back-to-front order. The selected $t_1$ check bits should be $\{n_T, n_{T-1}, ..., n_W\}$, where there are a total of $t_1$ indexes from T to W.

The transmit end sends the $t_1$ check bits.

The receive end receives the $t_1$ check bits, combines a sequence corresponding to the $t_1$ check bits and a sequence received during initial transmission into one sequence, and decodes the combined sequence.

If the receive end successfully decodes all the system bits based on the combined sequence, the decoding succeeds.

If the receive end still fails to restore all the system bits based on the combined sequence, and the maximum quantity of retransmissions is not reached, next retransmission is performed.

When second retransmission is performed, the transmit end may send $t_2$ check bits with second lowest priorities in the L check bits punctured in the initial transmission, where $t_2$ is an integer.

Specifically, the transmit end may select the $t_2$ check bits from $\{n_1, n_2, ..., n_{W-1}\}$ in back-to-front order. The selected $t_2$ check bits should be $\{n_{W-1}, n_{W-2}, ..., n_Q\}$, where there are a total of $t_2$ indexes from W-1 to Q, Q is a positive integer, and $Q \geq 1$.

The transmit end sends the $t_2$ check bits.

The receive end receives the $t_2$ check bits, combines a sequence corresponding to the $t_2$ check bits, the sequence corresponding to the $t_1$ check bits, and the sequence received during initial transmission into one sequence, and then decodes the combined sequence.

The rest may be deduced by analogy until the transmit end sends all check bits in $\{n_1, n_2, ..., n_T\}$. In this case, if the receive end still cannot correctly restore the system bits, it indicates that the data packet fails to be transmitted, and the transmission ends.

It can be learned from the foregoing process that during initial transmission, when selecting a check bit that needs to be punctured, the transmit end preferentially punctures a check bit with a high priority, that is, preferentially punctures a check bit with high sensitivity and low reliability. During retransmission, a check bit with a low priority in punctured check bits is preferentially sent. The transmit end follows such a principle, so that a probability of successful decoding by the receive end can be increased.

In addition, because a success rate of decoding by the receive end is improved, a quantity of retransmissions is reduced, and a retransmission delay is reduced.

The transmit end continuously fills punctured check bits, so that the code rate is continuously reduced, for example, gradually reduced from 5/6 to 3/4, 2/3, 1/2, or the like. This can meet a requirement of increasing a redundant bit through retransmission in the IR-HARQ mechanism to reduce a channel coding rate, and can improve decoding performance.

With reference to FIG. 1 to FIG. 9, the foregoing describes in detail a process in which the receive end performs rate matching on the LDPC code and the decoding process of the receive end. The following provides BER simulation results of the puncturing solution in this embodiment of this application and the puncturing solution in the 802.1lac standard.

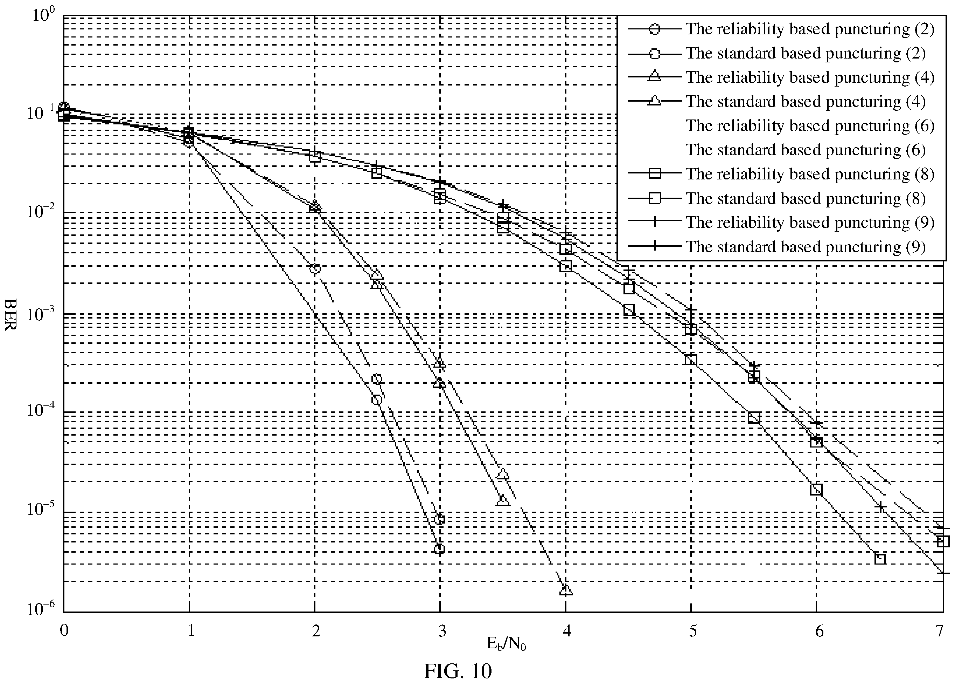

FIG. 10 to FIG. 23 are diagrams of comparisons between BER performance curves of LDPC codes with different quantities of to-be-punctured bits and BER performance curves of conventional puncturing solutions according to this application.

Simulation parameters in FIG. 10 to FIG. 23 are set as follows: AWGAN channel; BPSK modulation; log-SPA decoding; a maximum quantity of iterative decoding times is 10; a stop-wait retransmission request policy is used; and a maximum quantity of transmissions for restoring data of each frame is 4.

In addition, performance evaluation parameters considered in FIG. 10 to FIG. 23 are mainly a frame error rate (frame error rate, FER) and throughput (throughput). Throughput = (Quantity of correctly received frames $\times$ k)/Total quantity of sent bits. k is a quantity of information bits of each frame. In addition, $E_s/N_0$ in each figure indicates a symbol signal-to-noise ratio, and $E_b/N_0$ indicates a bit error rate.

An LDPC code in a conventional method is a QC-LDPC code whose code length is 1944 or 972 in an 802.11ac standard.

Specifically, FIG. 10 shows a comparison between BER performance of a check bit of an LDPC code whose code length is 1944 and BER performance in a conventional solution in a case of different quantities of to-be-punctured bits.

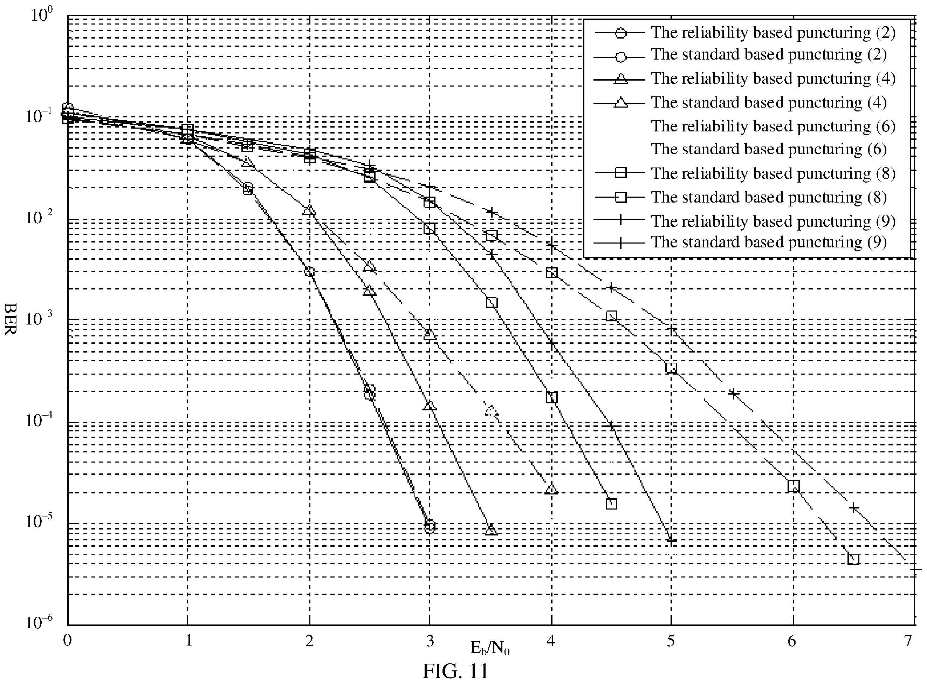

Specifically, FIG. 11 shows a comparison between BER performance of a check bit of an LDPC code whose code length is 1296 and BER performance in a conventional solution in a case of different quantities of to-be-punctured bits.

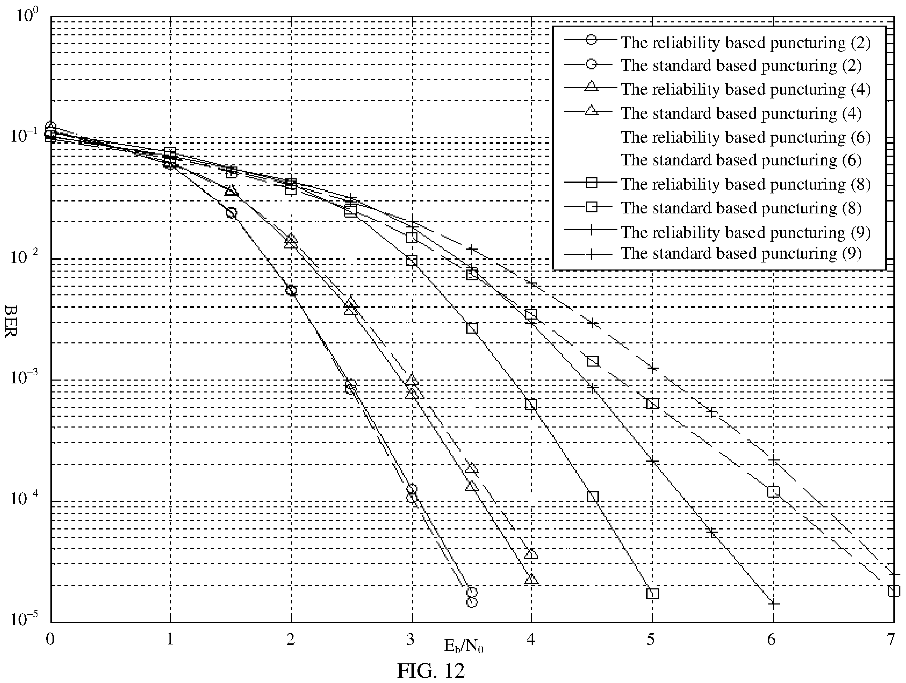

Specifically, FIG. 12 shows a comparison between BER performance of a check bit of an LDPC code whose code length is 648 and BER performance in a conventional solution in a case of different quantities of to-be-punctured bits.

In legends in FIG. 10 to FIG. 12, "the reliability based puncturing" indicates performance of a puncturing solution in this application, and "the standard-based puncturing" indicates performance of a conventional puncturing solution. A number in a bracket following "puncturing" indicates a quantity of to-be-punctured bits, which are puncturing two columns, four columns, six columns, eight columns, and nine columns in the table 2.

It can be learned that, for a same $E_s/N_0$, a FER in the puncturing solution in this application is lower. It indicates that the puncturing solution in this application outperforms the conventional puncturing solution.

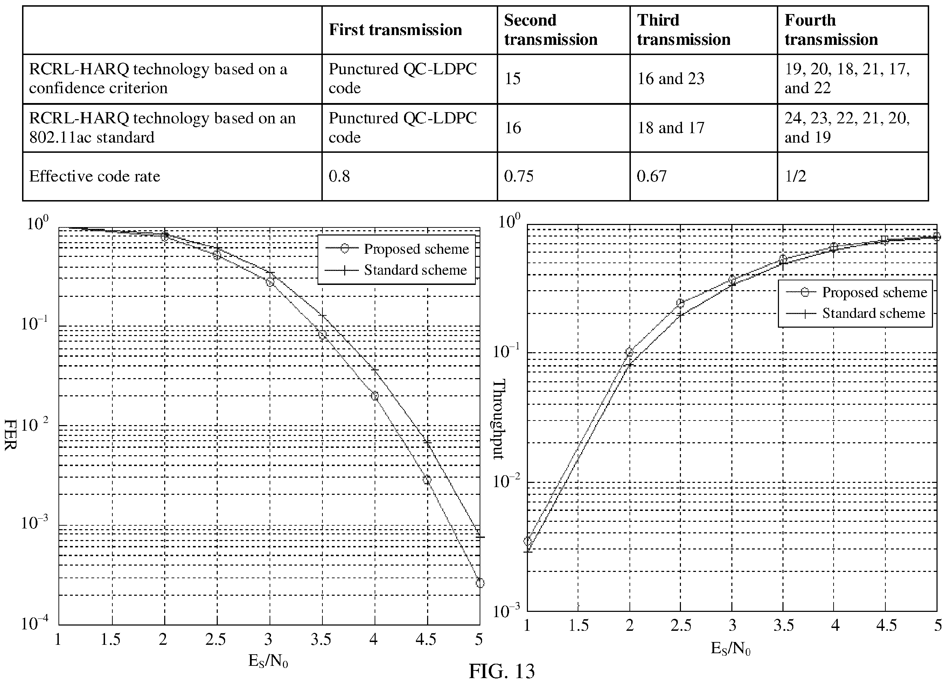

FIG. 13 is an application example of a puncturing solution of an LDPC code whose maximum quantity of retransmissions is 3 and whose code length is 1944 in the IR-HARQ mechanism.

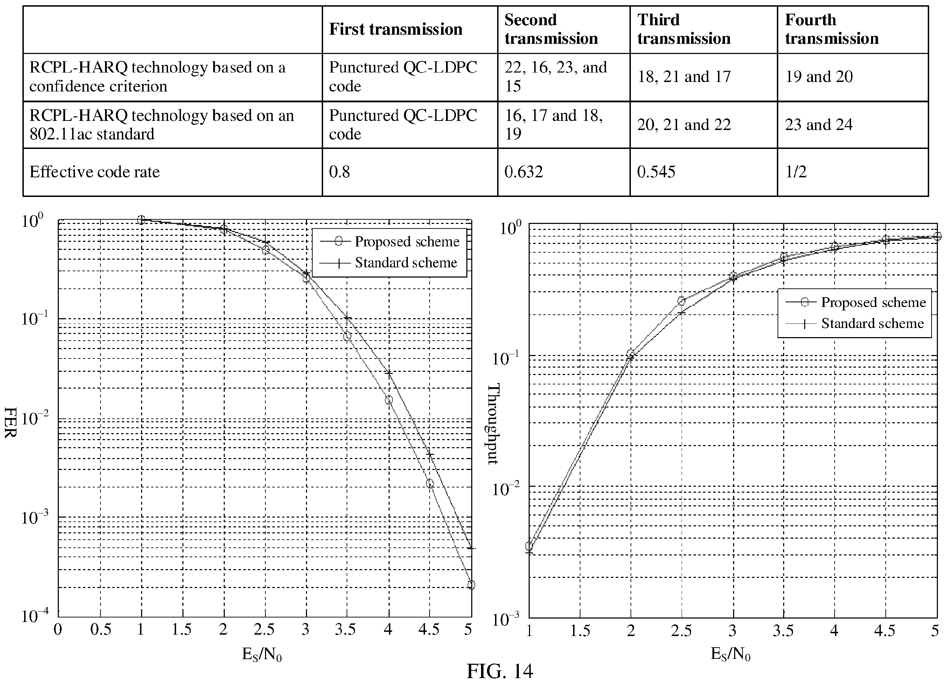

FIG. 14 is another application example of a puncturing solution of an LDPC code whose maximum quantity of retransmissions is 3 and whose code length is 1944 in the IR-HARQ mechanism.

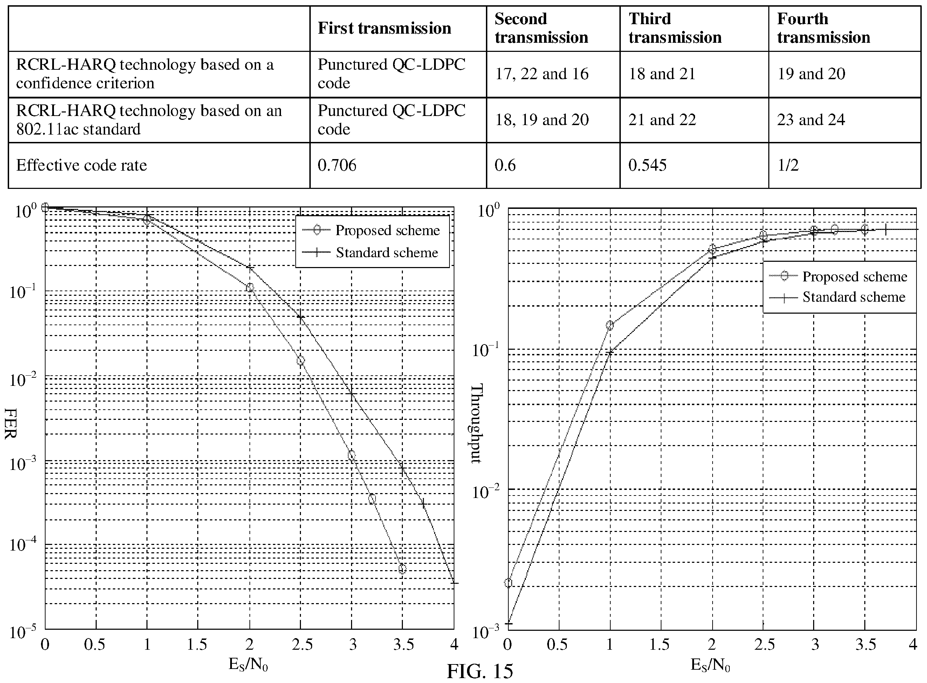

FIG. 15 is still another application example of a puncturing solution of an LDPC code whose maximum quantity of retransmissions is 3 and whose code length is 1944 in the IR-HARQ mechanism.

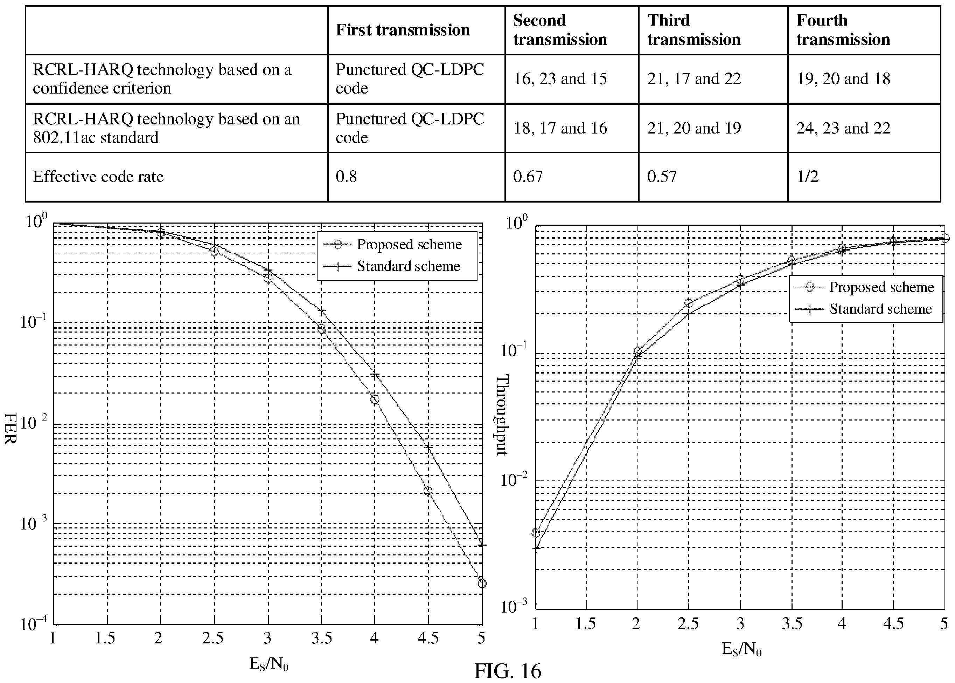

FIG. 16 is yet another application example of a puncturing solution of an LDPC code whose maximum quantity of retransmissions is 3 and whose code length is 1944 in the IR-HARQ mechanism.

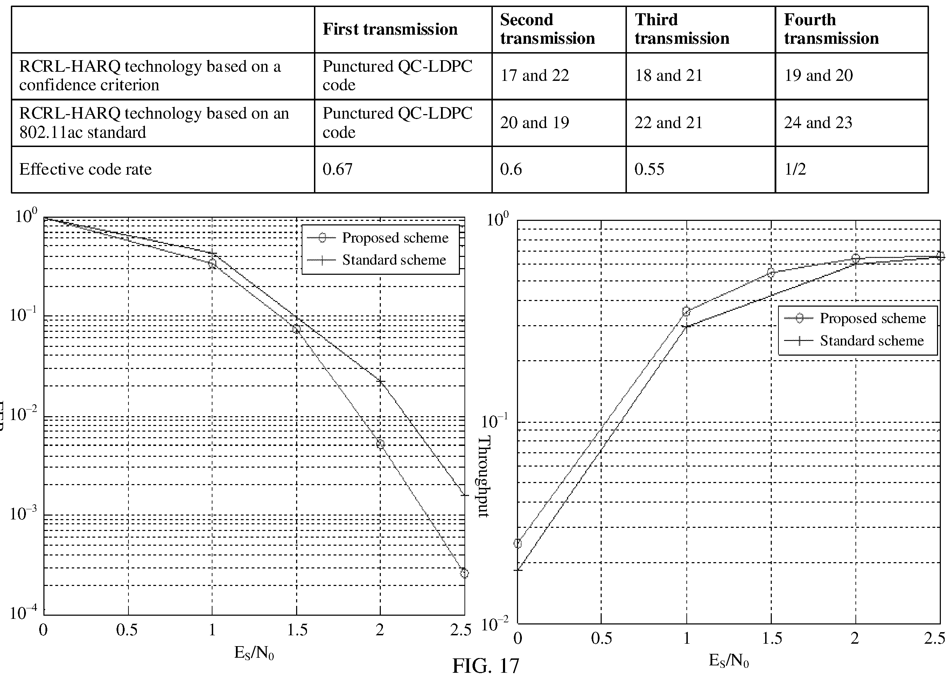

FIG. 17 is still yet another application example of a puncturing solution of an LDPC code whose maximum quantity of retransmissions is 3 and whose code length is 1944 in the IR-HARQ mechanism.

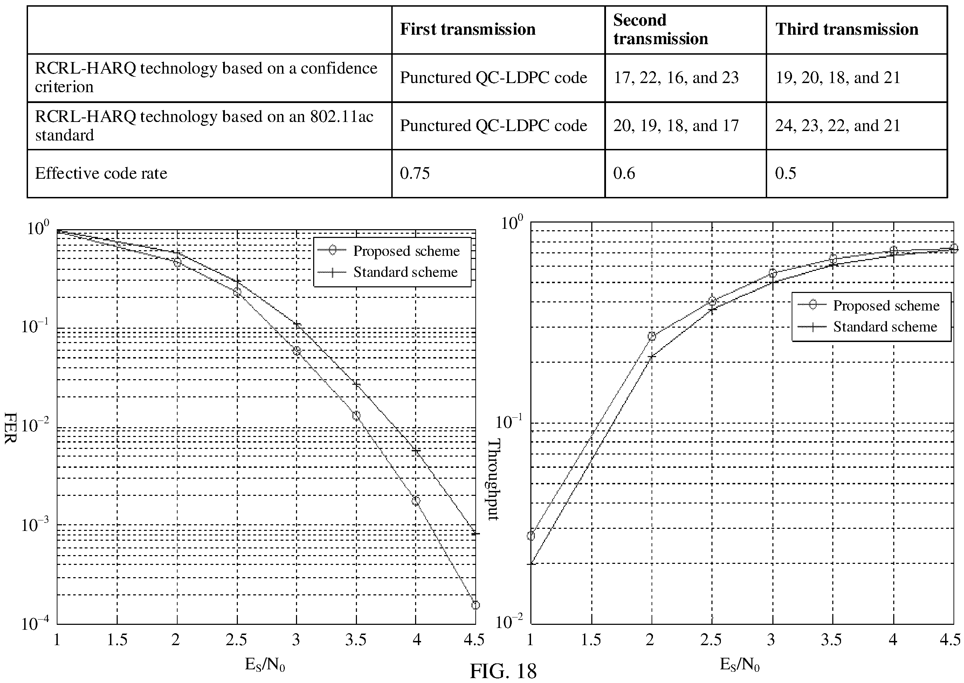

FIG. 18 is a further application example of a puncturing solution of an LDPC code whose maximum quantity of retransmissions is 3 and whose code length is 1944 in the IR-HARQ mechanism.

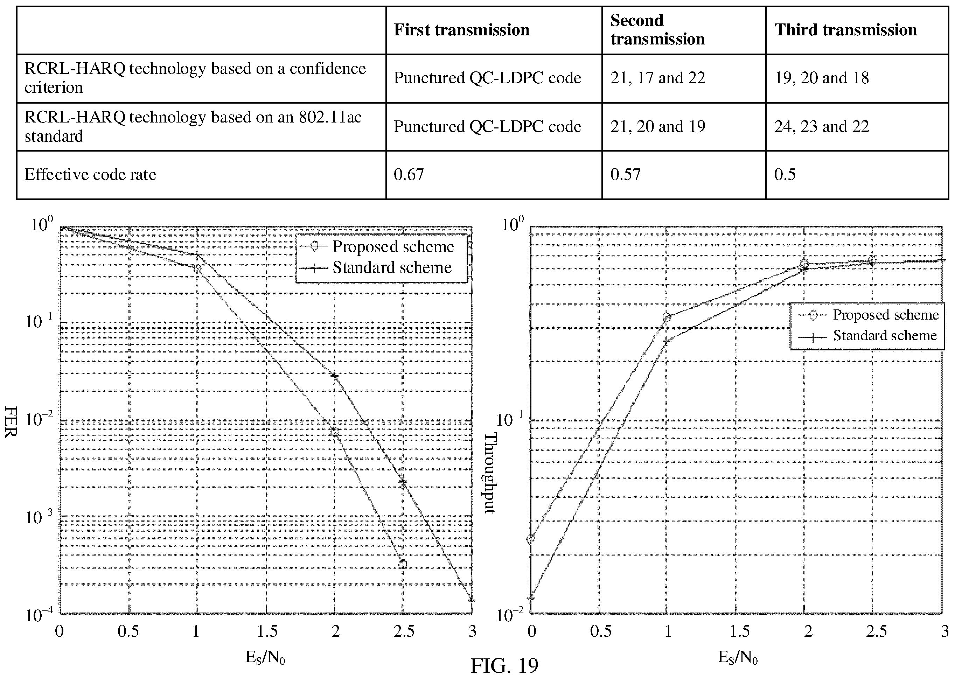

FIG. 19 is an application example of a puncturing solution of an LDPC code whose maximum quantity of retransmissions is 2 and whose code length is 1944 in the IR-HARQ mechanism.

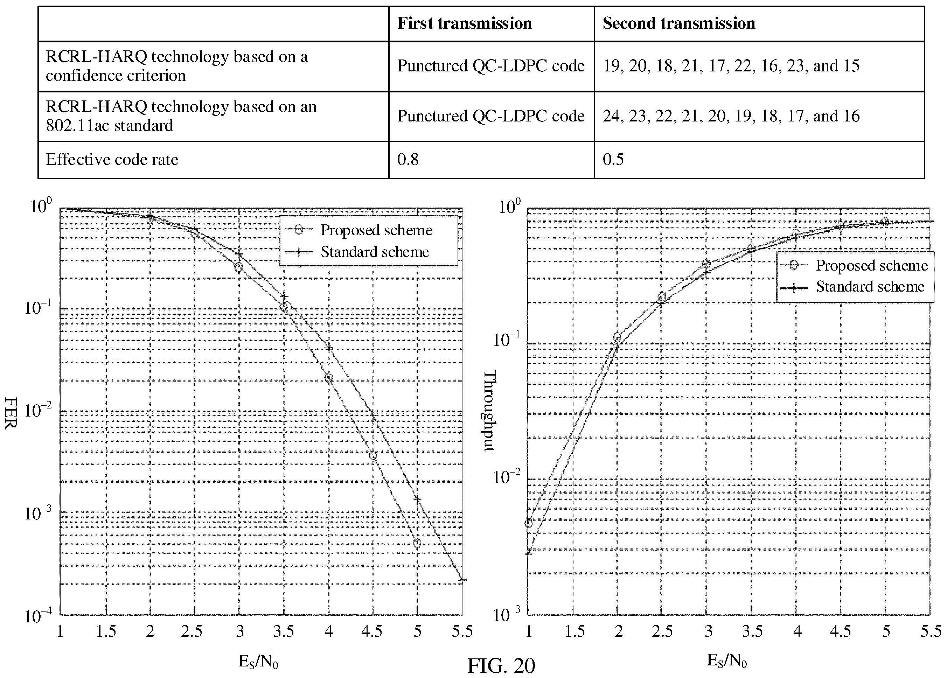

FIG. 20 is an application example of a puncturing solution of an LDPC code whose maximum quantity of retransmissions is 1 and whose code length is 1944 in the IR-HARQ mechanism.

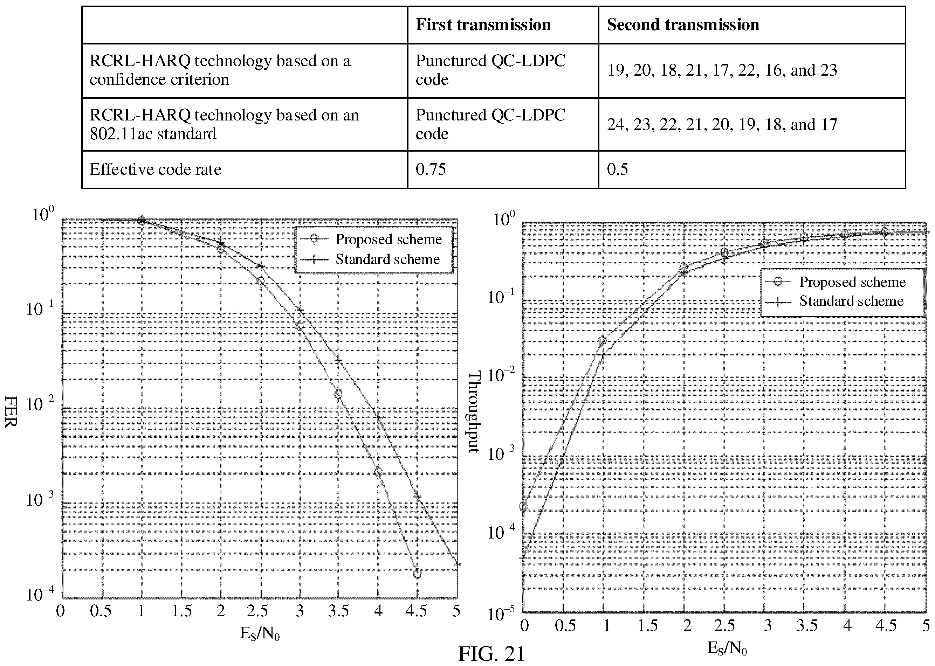

FIG. 21 is another application example of a puncturing solution of an LDPC code whose maximum quantity of retransmissions is 1 and whose code length is 1944 in the IR-HARQ mechanism.

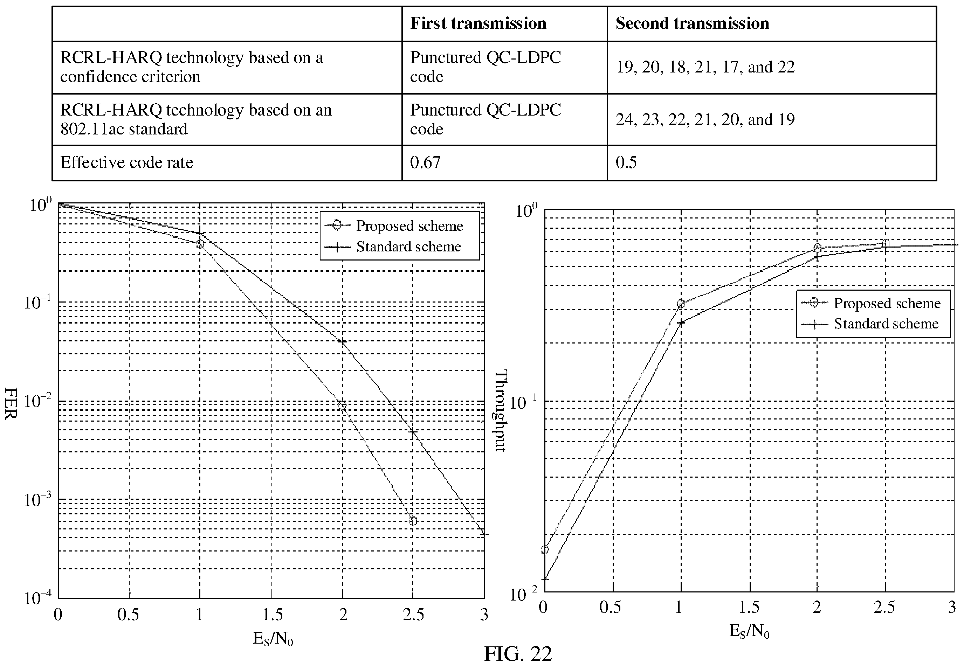

FIG. 22 is still another application example of a puncturing solution of an LDPC code whose maximum quantity of retransmissions is 1 and whose code length is 1944 in the IR-HARQ mechanism.

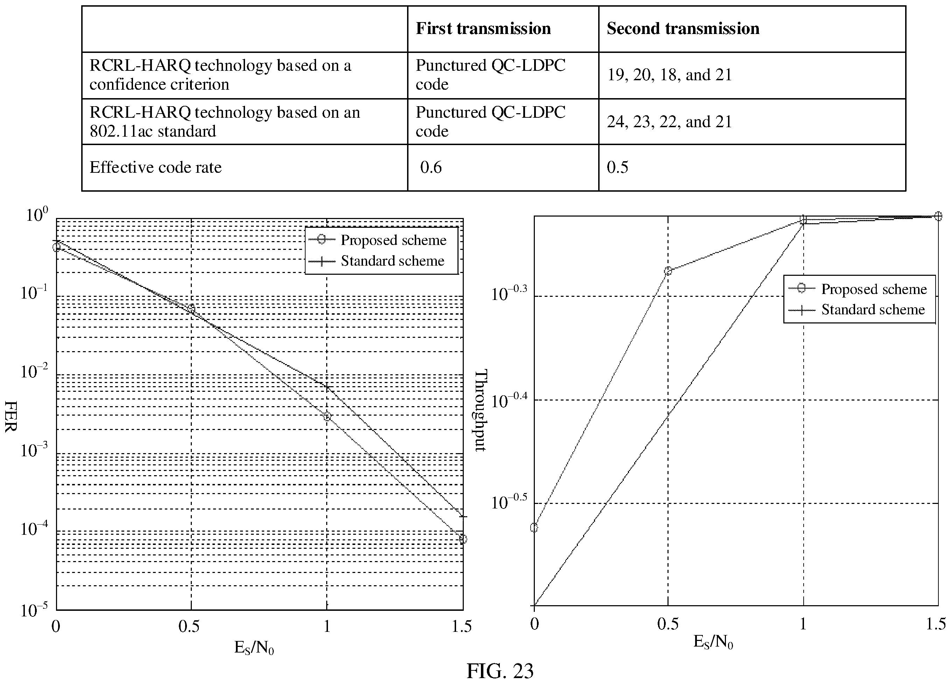

FIG. 23 is yet another application example of a puncturing solution of an LDPC code whose maximum quantity of retransmissions is 1 and whose code length is 1944 in the IR-HARQ mechanism.

In the legends in FIG. 13 to FIG. 23, each "proposed scheme" indicates a solution provided in this application, and each "standard scheme" indicates a solution a standard (namely, the foregoing 802.11ac standard), namely, a conventional solution.

It can be seen from FIG. 13 to FIG. 23 that, for a same Es/N0, in this application, an FER is lower and a throughput is higher. It indicates that the puncturing solution in this application outperforms the conventional puncturing solution.

The following describes communication apparatuses in this application.

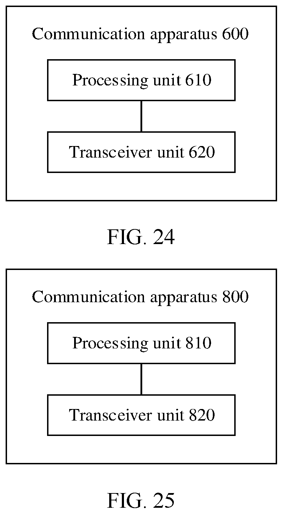

FIG. 24 is a schematic block diagram of a communication apparatus 600 according to this application. As shown in FIG. 24, the communication apparatus 600 includes a processing unit 610 and a transceiver unit 620.

The processing unit 610 is configured to perform rate matching on a first LDPC codeword with a first code rate based on a priority order of check bits of a mother code of an LDPC code, to obtain a second LDPC codeword with a second code rate, where the priority order indicates sorting of priorities of puncturing the check bits of the mother code during rate matching.

The transceiver unit 620 is configured to send the second LDPC codeword.

Optionally, in an embodiment, the processing unit 610 is further configured to:
puncture, based on a required quantity L of to-be-punctured bits and the priority order of the check bits of the mother code, check bits that are corresponding to first L bit positions sorted in descending order of priorities and that are in the first LDPC codeword, where $L \geq 1$, and L is an integer.

Optionally, in an embodiment, the priority order indicates an order of priorities of columns corresponding to the check bits in a check matrix of the mother code, each column corresponding to a check bit in the check matrix of the mother code is corresponding to z check bits of the mother code, z = N/n, N is a code length of the mother code, and n indicates a total quantity of columns included in the check matrix of the mother code.

Optionally, in an embodiment, the code length of the mother code is 1944, a code rate is 1/2, and priorities of the columns corresponding to the check bits in the check matrix of the mother code are sorted in descending order as follows:

19, 20, 18, 21, 17, 22, 16, 23, 15, 24, 14, and 13, where each element a in the sorting indicates an $a^{th}$ column of the check matrix.

Optionally, in an embodiment, the code length of the mother code is 1296, a code rate is 1/2, and priorities of the columns corresponding to the check bits in the check matrix of the mother code are sorted in descending order as follows:

20, 15, 21, 14, 19, 23, 16, 24, 18, 22, 17, and 13, where each element a in the sorting indicates an $a^{th}$ column of the check matrix.

Optionally, in an embodiment, the code length of the mother code is 1296, a code rate is 1/2, and priorities of the columns corresponding to the check bits in the check matrix of the mother code are sorted in descending order as follows:

20, 15, 21, 14, 19, 23, 16, 24, 18, 22, 17, and 13, where each element a in the sorting indicates an $a^{th}$ column of the check matrix.

Optionally, in an embodiment, priorities of the z check bits corresponding to each column corresponding to the check bit in the check matrix of the mother code are the same.

Optionally, in an embodiment, if L < z, the processing unit 610 is configured to puncture, based on the priority order, N check bits in z check bits corresponding to a column with a highest priority in the check matrix of the mother code.

Alternatively, if L > z, the processing unit 610 is configured to puncture, based on the priority order, L check bits in tz check bits corresponding to first t columns whose priorities are in descending order and that are in the check matrix of the mother code, where the L check bits include z(t-1) check bits corresponding to first (t-1) columns in the t columns and p check bits in a $t^{th}$ column, the p check bits are any p check bits in z check bits corresponding to the $t^{th}$ column, both t and p are positive numbers, and p $\leq$ z.

Alternatively, if L = mz, the processing unit 610 is configured to puncture, based on the priority order, z check bits corresponding to each of m columns with highest priorities in the check matrix of the mother code, where m$\geq$1 and m is an integer.

Optionally, in an embodiment, the transceiver unit 620 is further configured to receive retransmission indication information.

The processing unit 610 is further configured to perform rate matching on a to-be-retransmitted codeword based on the priority order of the check bits of the mother code, to obtain a third LDPC codeword with a third code rate, where the to-be-retransmitted codeword is obtained by performing LDPC encoding on to-be-retransmitted bits, and a puncturing position set of check bits of the third LDPC codeword is a proper subset of a puncturing position set of check bits of the second LDPC codeword.

The transceiver unit 620 is further configured to send the third codeword.

Optionally, the transceiver unit 620 may alternatively be replaced with a sending unit or a receiving unit. For example, when performing a sending action, the transceiver unit 620 may be replaced with the sending unit. When performing a receiving action, the transceiver unit 620 may be replaced with the receiving unit.

Optionally, the communication apparatus 600 may be a transmit device, or the communication apparatus 600 may be a component, a module, or the like that is inside the transmit device and that has a function of implementing the method embodiments.

In an implementation, the communication apparatus 600 is the transmit end in the foregoing method embodiments, and the communication apparatus 600 may have any function of the transmit end in the method embodiments. In this case, the processing unit 610 may be a processor. The transceiver unit 620 may be a transceiver. The transceiver may specifically include a receiver and a transmitter. The receiver is configured to perform a receiving function, and the transmitter is configured to perform a transmitting function.

Optionally, in another implementation, the communication apparatus 600 may be a circuit system in a transmit device. In this case, the processing unit 610 may be a chip, a logic circuit, an integrated circuit, a processing circuit, a system on chip (system on chip, SoC) chip, or the like. The transceiver unit 620 may be a communication interface. The communication interface may be an interface circuit, an input/output interface, or the like.

In an embodiment, the communication apparatus 600 may be an encoder in a transmit device.

In the foregoing embodiments, a function of the processing unit 610 may be implemented by hardware, or may be implemented by hardware by executing corresponding software.

For example, the processing unit 610 may include one or more processors. The one or more processors are configured to read and execute a computer program or instructions stored in a memory, so that operations and/or processing performed by the transmit end in the method embodiments are performed. The memory is located outside the one or more processors.

Further, the processing unit 610 may further include one or more memories. The one or more processors are connected to the one or more memories by using a circuit/wire. The one or more processors may read a computer program or instructions stored in the one or more memories, so that operations and/or processing performed by the transmit end in the method embodiments of this application are performed.

For another example, the processing unit 610 is a processor, and the transceiver unit 620 may be an interface circuit. The interface circuit is configured to receive computer code or instructions, and transmit the computer code or the instructions to the processor. The processor executes the computer code or the instructions, so that operations and/or processing performed by the transmit end in the method embodiments of this application are/is performed.

FIG. 25 is a schematic block diagram of a communication apparatus 800 according to this application. As shown in FIG. 25, the communication apparatus 800 includes a processing unit 810 and a transceiver unit 820.

The transceiver unit 810 is configured to receive a first channel receiving sequence.

The processing unit 820 is configured to: pad, with zeros based on a priority order of check bits of a mother code of an LDPC code, corresponding puncturing positions of a first LLR sequence corresponding to the first channel receiving sequence, and decode a first LLR sequence obtained through zero-padding. The corresponding puncturing positions of the first LLR sequence are positions of check bits that are punctured in a rate matching process in an LDPC codeword corresponding to the first channel receiving sequence.

The transceiver unit 810 is further configured to request a transmit end to perform retransmission.

Optionally, in an embodiment, the check bit that is punctured during rate matching process in the LDPC codeword corresponding to the first channel receiving sequence is a check bit corresponding to first L bit positions with highest priorities in the priority order, L is a quantity of check bits that need to be punctured, and L is an integer.

Optionally, in an embodiment, the priority order indicates sorting of priorities of columns corresponding to the check bits in a check matrix of the mother code of the LDPC. Each column corresponding to a check bit in the check matrix is corresponding to z codeword bits of the mother code. z = N/n, N indicates a code length of the LDPC code, n indicates a total quantity of columns included in the check matrix of the mother code, and N and n are integers.

Optionally, in an embodiment, the length of the mother code is 1944, a code rate is 1/2, and priorities of the columns corresponding to the check bits in the check matrix of the mother code are sorted in descending order as follows: 19, 20, 18, 21, 17, 22, 16, 23, 15, 24, 14, and 13.

Each element a in the sorting indicates an $a^{th}$ column of the check matrix.

Optionally, in an embodiment, a length of the mother code is 1296, a code rate is 1/2, and priorities of the columns corresponding to the check bits in the check matrix of the mother code are sorted in descending order as follows: 20, 15, 21, 14, 19, 23, 16, 24, 18, 22, 17, and 13.

Each element a in the sorting indicates an $a^{th}$ column of the check matrix.

Optionally, in an embodiment, a length of the mother code is 648, a code rate is 1/2, and priorities of the columns corresponding to the check bits in the check matrix of the mother code are sorted in descending order as follows: 21, 15, 22, 23, 18, 19, 14, 24, 20, 16, 17, and 13.

Each element a in the sorting indicates an $a^{th}$ column of the check matrix.

Optionally, in an embodiment, priorities of the z codeword bits corresponding to each column corresponding to the check bit in the check matrix of the mother code are the same.

Optionally, in an embodiment, if L < z, the punctured check bit is any L check bits in z check bits corresponding to a column with a highest priority in the check matrix.

Alternatively, if L > z, the punctured check bit is L check bits in check bits corresponding to first t columns sorted in descending order in the check matrix, where the L check bits include z(t-1) check bits corresponding to first (t-1) columns and p check bits in a $t^{th}$ column, the p check bits are any p check bits in z check bits corresponding to the $t^{th}$ column, both t and p are positive numbers, and $p \leq z$.

If L = mz, the punctured check bit is z check bits corresponding to each of m columns with highest priorities in the check matrix, where $m \geq 1$, and m is an integer.

Optionally, in an embodiment, the transceiver unit 820 is further configured to:

send retransmission indication information to the transmit end; and
receive a second channel receiving sequence.

The processing unit 810 is further configured to: pad, with zeros based on the priority order of the check bits of the mother code, corresponding puncturing positions in a second LLR sequence corresponding to the second channel receiving sequence, and decode a combined sequence of a second LLR sequence obtained through zero-padding and the first LLR sequence obtained through zero-padding. A set including puncturing positions that need to be padded with zeros in the second LLR sequence is a proper subset of a set including puncturing positions that need to be padded with zeros in the first LLR sequence.

Optionally, the transceiver unit 820 may alternatively be replaced with a sending unit or a receiving unit. For example, when performing a sending action, the transceiver unit 820 may be replaced with the sending unit. When performing a receiving action, the transceiver unit 820 may be replaced with the receiving unit.

Optionally, the communication apparatus 800 may be a receive end, or the communication apparatus 800 may be a component, a module, or the like that is inside the receive end and that has a function of implementing the method embodiments.

In an implementation, the communication apparatus 800 is the receive end in the foregoing method embodiments, and the communication apparatus 800 may have any function of the receive device in the method embodiments. In this case, the processing unit 810 may be a processor, and the transceiver unit 820 may be a transceiver. The transceiver may specifically include a receiver and a transmitter. The receiver is configured to perform a receiving function, and the transmitter is configured to perform a transmitting function.

In another implementation, the communication apparatus 800 may be a circuit system of the receive end. In this case, the processing unit 810 may be a chip, a logic circuit, an integrated circuit, a processing circuit, a SoC chip, or the like. The transceiver unit 820 may be a communication interface. The communication interface may be an interface circuit, an input/output interface, or the like.

In an embodiment, the communication apparatus 600 may be a decoder in the receive device.

In the foregoing embodiments, a function of the processing unit 810 may be implemented by hardware, or may be implemented by hardware by executing corresponding software.

For example, the processing unit 810 may include one or more processors. The one or more processors are configured to read and execute a computer program or instructions stored in a memory, so that operations and/or processing performed by the receive end in the method embodiments are performed. The memory is located outside the one or more processors.

Further, the processing unit 810 may further include one or more memories. The one or more processors are connected to the one or more memories by using a circuit/wire. The one or more processors may read a computer program or instructions stored in the one or more memories, so that operations and/or processing performed by the receive end in the method embodiments of this application are performed.

For another example, the processing unit 810 is a processor, and the transceiver unit 820 is an interface circuit. The interface circuit is configured to receive computer code or instructions, and transmit the computer code or the instructions to the processor. The processor executes the computer code or the instructions, so that operations and/or processing performed by the receive end in the method embodiments of this application are/is performed.

Optionally, the memory and the processor in the foregoing apparatus embodiments may be physically independent units, or the memory may be integrated with the processor.

In addition, this application further provides a computer-readable storage medium. The computer-readable storage medium stores computer instructions. When the computer instructions are run on a computer, operations and/or processing performed by a transmit end in the LDPC code rate matching method provided in this application are/is performed.

This application further provides a computer-readable storage medium. The computer-readable storage medium stores computer instructions. When the computer instructions are run on a computer, the computer is enabled to perform operations and/or processing performed by a receive end in the LDPC code decoding method provided in this application.

This application further provides a computer program product. The computer program product includes computer code or instructions. When the computer code or the instructions is run or are run on a computer, the LDPC code rate matching method in the method embodiments of this application is implemented.

This application further provides a computer program product. The computer program product includes computer code or instructions. When the computer code or the instructions is run or are run on a computer, the LDPC code decoding method in the method embodiments of this application is implemented.

This application further provides a communication apparatus, including a processor and an interface circuit. The interface circuit is configured to receive computer code or instructions, and transmit the computer code or instructions to the processor, and the processor is configured to run the computer code or instructions, so that operations and/or processing performed by a transmit end in the LDPC code rate matching method provided in this application is performed.

This application further provides a communication apparatus, including a processor and an interface circuit. The interface circuit is configured to receive computer code or instructions, and transmit the computer code or instructions to the processor, and the processor is configured to run the computer code or instructions, so that operations and/or processing performed by a receive end in the LDPC code decoding method provided in this application is performed.

This application further provides a chip. The chip includes one or more processors. The one or more processors are configured to execute a computer program stored in a memory, to perform operations and/or processing performed by a transmit device in any method embodiment. The memory is disposed independent of the chip.

Further, the chip may further include one or more communication interfaces. The one or more communication interfaces may be an input/output interface, an interface circuit, or the like. Further, the chip may further include one or more memories.

This application further provides a chip. The chip includes one or more processors. The one or more processors are configured to execute a computer program stored in a memory, to perform operations and/or processing performed by a receive device in any method embodiment. The memory is disposed independent of the chip.

Further, the chip may further include one or more communication interfaces. The one or more communication interfaces may be an input/output interface, an interface circuit, or the like. Further, the chip may further include one or more memories.

This application further provides a wireless communication system, including a transmit end and a receive end in embodiments of this application.

Optionally, one of the transmit end and the receive end is a network device (for example, a base station), and the other is a terminal device.

The processor in this embodiment of this application may be an integrated circuit chip, and has a signal processing capability. In an implementation process, steps in the foregoing method embodiments can be implemented by using a hardware integrated logical circuit in the processor, or by using instructions in a form of software. The processor may be a general-purpose processor, a digital signal processor (digital signal processor, DSP), an application-specific integrated circuit (application specific integrated circuit, ASIC), a field programmable gate array (field programmable gate array, FPGA) or another programmable logic device, a discrete gate or a transistor logic device, or a discrete hardware component. The general-purpose processor may be a microprocessor, or the processor may be any conventional processor or the like. The steps of the methods disclosed in embodiments of this application may be directly presented as being performed and completed by a hardware encoding processor, or performed and completed by a combination of hardware and a software module in an encoding processor. A software module may be located in a mature storage medium in the art, such as a random access memory, a flash memory, a read-only memory, a programmable read-only memory, an electrically erasable programmable memory, or a register. The storage medium is located in the memory, and a processor reads information in the memory and completes the steps in the foregoing methods in combination with hardware of the processor.

The memory in embodiments of this application may be a volatile memory or a nonvolatile memory, or may include a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. Through examples but not limitative description, RAMs in many forms are available, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DRRAM). It should be noted that the memory of the systems and methods described in this specification includes but is not limited to these and any memory of another proper type.

The terms such as "unit", and "system" used in this specification indicate computer-related entities, hardware, firmware, combinations of hardware and software, software, or software being executed. For example, a component may be, but is not limited to, a process that runs on a processor, a processor, an object, an executable file, an execution thread, a program, and/or a computer. As illustrated by using figures, both a computing device and an application that runs on the computing device may be components. One or more components may reside within the process and/or the execution thread. The components may be located on one computer and/or distributed between two or more computers. In addition, these components may be executed from various computer-readable media that store various data structures. The components may communicate by using a local and/or remote process based on a signal having one or more data packets (for example, data from two components interacting with another component in a local system, a distributed system, and/or another network, such as the Internet for interacting with another system by using the signal).

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments, and details are not described herein again.

In the several embodiments provided in this application, it should be understood that the disclosed system, apparatus, and method may be implemented in other manners. For example, the described apparatus embodiment is merely an example. For example, division into the units is merely logical function division and may be other division during actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units may be integrated into one unit.

When the functions are implemented in the form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, a network device, or the like) to perform all or some of the steps of the methods described in embodiments of this application. The foregoing storage medium includes any medium that can store program code, such as a removable hard disk, a read-only memory, a random access memory, a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An LDPC code rate matching method, comprising:

   performing, by a transmit end, rate matching on a first low-density parity check LDPC codeword with a first code rate based on a priority order of check bits of a mother code of an LDPC code, to obtain a second LDPC codeword with a second code rate, wherein the priority order indicates sorting of priorities of puncturing the check bits of the mother code during rate matching; and
   sending, by the transmit end, the second LDPC codeword.

2. The method according to claim 1, wherein the performing, by a transmit end, rate matching on a first LDPC codeword with a first code rate based on a priority order of check bits of a mother code comprises:
   puncturing, by the transmit end based on a required quantity L of to-be-punctured bits and the priority order of the check bits of the mother code, check bits that are corresponding to first L bit positions in descending order of priorities and that are in the first LDPC codeword, wherein $L \geq 1$, and N is an integer.

3. The method according to claim 1 or 2, wherein the priority order indicates an order of priorities of columns corresponding to the check bits in a check matrix of the mother code, each column corresponding to a check bit in the check matrix of the mother code is corresponding to z check bits of the mother code, $z = N/n$, N is a code length of the mother code, and n indicates a total quantity of columns comprised in the check matrix of the mother code.

4. The method according to claim 3, wherein the code length of the mother code is 1944, a code rate is 1/2, and priorities of the columns corresponding to the check bits in the check matrix of the mother code are sorted in descending order as follows:

   19, 20, 18, 21, 17, 22, 16, 23, 15, 24, 14, and 13, wherein
   each element a in the sorting indicates an $a^{th}$ column of the check matrix.

5. The method according to claim 3, wherein the code length of the mother code is 1296, a code rate is 1/2, and priorities of the columns corresponding to the check bits in the check matrix of the mother code are sorted in descending order as follows:

20, 15, 21, 14, 19, 23, 16, 24, 18, 22, 17, and 13, wherein
each element a in the sorting indicates an $a^{th}$ column of the check matrix.

6. The method according to claim 3, wherein the code length of the mother code is 648, a code rate is 1/2, and priorities of the columns corresponding to the check bits in the check matrix of the mother code are sorted in descending order as follows:

21, 15, 22, 23, 18, 19, 14, 24, 20, 16, 17, and 13, wherein
each element a in the sorting indicates an $a^{th}$ column of the check matrix.

7. The method according to any one of claims 4 to 6, wherein priorities of the z check bits corresponding to each column corresponding to the check bit in the check matrix of the mother code are the same.

8. The method according to claim 7, wherein the puncturing, by the transmit end based on a required quantity L of to-be-punctured bits and the priority order of the check bits of the mother code, check bits that are corresponding to first L bit positions sorted in descending order of priorities and that are in the first LDPC codeword comprises:

if L < z, puncturing, by the transmit end based on the priority order, N check bits in z check bits corresponding to a column with a highest priority in the check matrix of the mother code;
if L > z, puncturing, by the transmit end based on the priority order, L check bits in tz check bits corresponding to first t columns whose priorities are in descending order and that are in the check matrix of the mother code, wherein the L check bits comprise z(t-1) check bits corresponding to first (t-1) columns in the t columns and p check bits in a $t^{th}$ column, the p check bits are any p check bits in z check bits corresponding to the $t^{th}$ column, both t and p are positive numbers, and $p \leq z$; or
if L = mz, puncturing, by the transmit end based on the priority order, mz check bits corresponding to m columns with highest priorities in the check matrix of the mother code, wherein $m \geq 1$ and m is an integer.

9. The method according to claim 8, wherein after the sending, by the transmit end, the second LDPC codeword, the method further comprises:

receiving, by the transmit end, retransmission indication information;
performing, by the transmit end, rate matching on a to-be-retransmitted codeword based on the priority order of the check bits of the mother code, to obtain a third LDPC codeword with a third code rate, wherein the to-be-retransmitted codeword is obtained by performing LDPC encoding on to-be-retransmitted bits, and a puncturing position set of check bits of the third LDPC codeword is a proper subset of a puncturing position set of check bits of the second LDPC codeword; and
sending, by the transmit end, the third LDPC codeword.

10. A communication apparatus, comprising:

a processing unit, configured to perform rate matching on a first LDPC codeword with a first code rate based on a priority order of check bits of a mother code, to obtain a second LDPC codeword with a second code rate, wherein the priority order indicates sorting of priorities of puncturing the check bits of the mother code during rate matching; and
a transceiver unit, configured to send the second LDPC codeword.

11. The communication apparatus according to claim 10, wherein the processing unit is specifically configured to: puncture, based on a required quantity L of to-be-punctured bits and the priority order of the check bits of the mother code, check bits that are corresponding to first L bit positions in descending order of priorities and that are in the first LDPC codeword, wherein $L \geq 1$, and N is an integer.

12. The communication apparatus according to claim 10 or 11, wherein the priority order indicates an order of priorities of columns corresponding to the check bits in a check matrix of the mother code, each column corresponding to a check bit in the check matrix of the mother code is corresponding to z check bits of the mother code, z = N/n, N is a code length of the mother code, and n indicates a total quantity of columns comprised in the check matrix of the mother code.

13. The communication apparatus according to claim 12, wherein the code length of the mother code is 1944, a code rate is 1/2, and priorities of the columns corresponding to the check bits in the check matrix of the mother code are sorted in descending order as follows:

19, 20, 18, 21, 17, 22, 16, 23, 15, 24, 14, and 13, wherein
each element a in the sorting indicates an $a^{th}$ column of the check matrix.

14. The communication apparatus according to claim 12, wherein the code length of the mother code is 1296, a code rate is 1/2, and priorities of the columns corresponding to the check bits in the check matrix of the mother code are sorted in descending order as follows:

20, 15, 21, 14, 19, 23, 16, 24, 18, 22, 17, and 13, wherein
each element a in the sorting indicates an $a^{th}$ column of the check matrix.

15. The communication apparatus according to claim 12, wherein the code length of the mother code is 648, a code rate is 1/2, and priorities of the columns corresponding to the check bits in the check matrix of the mother code are sorted in descending order as follows:

21, 15, 22, 23, 18, 19, 14, 24, 20, 16, 17, and 13, wherein
each element a in the sorting indicates an $a^{th}$ column of the check matrix.

16. The communication apparatus according to any one of claims 13 to 15, wherein priorities of the z check bits corresponding to each column corresponding to the check bit in the check matrix of the mother code are the same.

17. The communication apparatus according to claim 16, wherein the processing unit is specifically configured to:

if $L < z$, puncture, based on the priority order, N check bits in z check bits corresponding to a column with a highest priority in the check matrix of the mother code;
if $L > z$, puncture, based on the priority order, L check bits in tz check bits corresponding to first t columns whose priorities are in descending order and that are in the check matrix of the mother code, wherein the L check bits comprise z(t-1) check bits corresponding to first (t-1) columns in the t columns and p check bits in a $t^{th}$ column, the p check bits are any p check bits in z check bits corresponding to the $t^{th}$ column, both t and p are positive numbers, and $p \leq z$; or
if $L = z$, puncture, based on the priority order, z check bits corresponding to a column with a highest priority in the check matrix of the mother code.

18. The communication apparatus according to claim 17, wherein the transceiver unit is further configured to receive retransmission indication information;

the processing unit is further configured to perform rate matching on a to-be-retransmitted codeword based on the priority order of the check bits of the mother code, to obtain a third LDPC codeword with a third code rate, wherein the to-be-retransmitted codeword is obtained by performing LDPC encoding on to-be-retransmitted bits, and a puncturing position set of check bits of the third LDPC codeword is a proper subset of a puncturing position set of check bits of the second LDPC codeword; and
the transceiver unit is further configured to send the third LDPC codeword.

19. A communication apparatus, comprising a processor and an interface circuit, wherein the interface circuit is configured to receive computer code or instructions, and transmit the computer code or the instructions to the processor, and when the processor runs the computer code or the instructions, the method according to any one of claims 1 to 9 is implemented.

20. A communication apparatus, comprising at least one processor, wherein the at least one processor is coupled to at least one memory, and the at least one processor is configured to execute a computer program or instructions stored in the at least one memory, to enable the communication apparatus to perform the method according to any one of claims 1 to 9.

21. A computer-readable storage medium, wherein the computer-readable storage medium stores computer instructions; and when the computer instructions are run on a computer, the method according to any one of claims 1 to 9 is implemented.

$$H = \begin{array}{cccccccc} V_1 & V_2 & V_3 & V_4 & V_5 & V_6 & V_7 & V_8 \\ \left[\begin{array}{cccccccc} 1 & 0 & 1 & 0 & 1 & 0 & 1 & 0 \\ 1 & 0 & 0 & 1 & 0 & 1 & 0 & 1 \\ 0 & 1 & 1 & 0 & 0 & 1 & 1 & 0 \\ 0 & 0 & 0 & 1 & 1 & 0 & 0 & 1 \end{array}\right] & \begin{array}{c} C_1 \\ C_2 \\ C_3 \\ C_4 \end{array} \end{array}$$

FIG. 1

FIG. 2

(a)

(b)

FIG. 3

400

Perform rate matching on a first LDPC codeword with a first code rate
based on a priority order of check bits of a mother code of an LDPC code, to
obtain a second LDPC codeword with a second code rate, where the priority
order indicates sorting of priorities of puncturing the check bits of the
mother code during rate matching                                    410

Send the second LDPC codeword                                       420

FIG. 4

| Priority order | $t_1$ | $t_2$ | ... | $t_k$ | ... |
|---|---|---|---|---|---|

| Encode | System bit | 0 | 1 | 2 | 3 | ... | $N_0-1$ |
|---|---|---|---|---|---|---|---|

| Puncture | System bit | 0 | 1 | 2 | 3 | ... | $N_1$ | ... | $N_p$ | ... | $N_0-1$ |
|---|---|---|---|---|---|---|---|---|---|---|---|

$t_2$      $t_1$      $t_k$

| Send | System bit | 0 | 2 | 3 | ... | $N_0-1$ |
|---|---|---|---|---|---|---|

FIG. 5

| Priority order | $t_1$ | $t_2$ | ... | $t_k$ | ... |
|---|---|---|---|---|---|

| Receive | System bit | 0 | 2 | 3 | ... | $N_0-1$ |
|---|---|---|---|---|---|

| Process | System bit | 0 | 0 | 2 | 3 | ... | 0 | ... | 0 | ... | $N_0-1$ |
|---|---|---|---|---|---|---|---|---|---|---|---|

$t_2$      $t_1$      $t_k$

Decode

FIG. 6

FIG. 7

FIG. 8

600

| Transmit end | | Receive end |

601: Perform LDPC encoding on K information bits based on a required code rate R and a code length N, to obtain a first LDPC codeword

602: Perform rate matching on the first LDPC codeword based on a priority order of check bits of a mother code, to obtain a second LDPC codeword

603: Second LDPC codeword
(Second code rate)

604: Pad, with zeros based on the priority order of the check bits of the LDPC code, corresponding puncturing positions of a first LLR sequence corresponding to the first channel receiving sequence, and then decodes a first LLR sequence obtained through zero-padding

605: Successfully decode the system bits, and output a decoding result

606: Retransmission indication information

607: Third LDPC codeword
(Third code rate)

608: Pad, with zeros based on the priority order of the LDPC code, corresponding puncturing positions of a second LLR sequence corresponding to the second channel receiving sequence, and decodes a combined sequence of a second LLR sequence that is padded with zeros and the first LLR sequence that is padded with zeros

609: Successfully decode the system bits, and output a decoding result

610: Continue retransmission until a maximum quantity of retransmissions is reached, or until decoding fails

FIG. 9

FIG. 10

FIG. 11

EP 4 109 794 A1

FIG. 12

EP 4 109 794 A1

| | First transmission | Second transmission | Third transmission | Fourth transmission |
|---|---|---|---|---|
| RCRL-HARQ technology based on a confidence criterion | Punctured QC-LDPC code | 15 | 16 and 23 | 19, 20, 18, 21, 17, and 22 |
| RCRL-HARQ technology based on an 802.11ac standard | Punctured QC-LDPC code | 16 | 18 and 17 | 24, 23, 22, 21, 20, and 19 |
| Effective code rate | 0.8 | 0.75 | 0.67 | 1/2 |

FIG. 13

| | First transmission | Second transmission | Third transmission | Fourth transmission |
|---|---|---|---|---|
| RCPL-HARQ technology based on a confidence criterion | Punctured QC-LDPC code | 22, 16, 23, and 15 | 18, 21 and 17 | 19 and 20 |
| RCPL-HARQ technology based on an 802.11ac standard | Punctured QC-LDPC code | 16, 17 and 18, 19 | 20, 21 and 22 | 23 and 24 |
| Effective code rate | 0.8 | 0.632 | 0.545 | 1/2 |

FIG. 14

EP 4 109 794 A1

|  | First transmission | Second transmission | Third transmission | Fourth transmission |
|---|---|---|---|---|
| RCRL-HARQ technology based on a confidence criterion | Punctured QC-LDPC code | 17, 22 and 16 | 18 and 21 | 19 and 20 |
| RCRL-HARQ technology based on an 802.11ac standard | Punctured QC-LDPC code | 18, 19 and 20 | 21 and 22 | 23 and 24 |
| Effective code rate | 0.706 | 0.6 | 0.545 | 1/2 |

FIG. 15

| | First transmission | Second transmission | Third transmission | Fourth transmission |
|---|---|---|---|---|
| RCRL-HARQ technology based on a confidence criterion | Punctured QC-LDPC code | 16, 23 and 15 | 21, 17 and 22 | 19, 20 and 18 |
| RCRL-HARQ technology based on an 802.11ac standard | Punctured QC-LDPC code | 18, 17 and 16 | 21, 20 and 19 | 24, 23 and 22 |
| Effective code rate | 0.8 | 0.67 | 0.57 | 1/2 |

FIG. 16

EP 4 109 794 A1

|  | First transmission | Second transmission | Third transmission | Fourth transmission |
|---|---|---|---|---|
| RCRL-HARQ technology based on a confidence criterion | Punctured QC-LDPC code | 17 and 22 | 18 and 21 | 19 and 20 |
| RCRL-HARQ technology based on an 802.11ac standard | Punctured QC-LDPC code | 20 and 19 | 22 and 21 | 24 and 23 |
| Effective code rate | 0.67 | 0.6 | 0.55 | 1/2 |

FIG. 17

EP 4 109 794 A1

|  | First transmission | Second transmission | Third transmission |
|---|---|---|---|
| RCRL-HARQ technology based on a confidence criterion | Punctured QC-LDPC code | 17, 22, 16, and 23 | 19, 20, 18, and 21 |
| RCRL-HARQ technology based on an 802.11ac standard | Punctured QC-LDPC code | 20, 19, 18, and 17 | 24, 23, 22, and 21 |
| Effective code rate | 0.75 | 0.6 | 0.5 |

FIG. 18

EP 4 109 794 A1

| | First transmission | Second transmission | Third transmission |
|---|---|---|---|
| RCRL-HARQ technology based on a confidence criterion | Punctured QC-LDPC code | 21, 17 and 22 | 19, 20 and 18 |
| RCRL-HARQ technology based on an 802.11ac standard | Punctured QC-LDPC code | 21, 20 and 19 | 24, 23 and 22 |
| Effective code rate | 0.67 | 0.57 | 0.5 |

FIG. 19

EP 4 109 794 A1

| | First transmission | Second transmission |
|---|---|---|
| RCRL-HARQ technology based on a confidence criterion | Punctured QC-LDPC code | 19, 20, 18, 21, 17, 22, 16, 23, and 15 |
| RCRL-HARQ technology based on an 802.11ac standard | Punctured QC-LDPC code | 24, 23, 22, 21, 20, 19, 18, 17, and 16 |
| Effective code rate | 0.8 | 0.5 |

FIG. 20

EP 4 109 794 A1

| | First transmission | Second transmission |
|---|---|---|
| RCRL-HARQ technology based on a confidence criterion | Punctured QC-LDPC code | 19, 20, 18, 21, 17, 22, 16, and 23 |
| RCRL-HARQ technology based on an 802.11ac standard | Punctured QC-LDPC code | 24, 23, 22, 21, 20, 19, 18, and 17 |
| Effective code rate | 0.75 | 0.5 |

FIG. 21

| | First transmission | Second transmission |
|---|---|---|
| RCRL-HARQ technology based on a confidence criterion | Punctured QC-LDPC code | 19, 20, 18, 21, 17, and 22 |
| RCRL-HARQ technology based on an 802.11ac standard | Punctured QC-LDPC code | 24, 23, 22, 21, 20, and 19 |
| Effective code rate | 0.67 | 0.5 |

FIG. 22

EP 4 109 794 A1

| | First transmission | Second transmission |
|---|---|---|
| RCRL-HARQ technology based on a confidence criterion | Punctured QC-LDPC code | 19, 20, 18, and 21 |
| RCRL-HARQ technology based on an 802.11ac standard | Punctured QC-LDPC code | 24, 23, 22, and 21 |
| Effective code rate | 0.6 | 0.5 |

FIG. 23

EP 4 109 794 A1

Communication apparatus 600

Processing unit 610

Transceiver unit 620

FIG. 24

Communication apparatus 800

Processing unit 810

Transceiver unit 820

FIG. 25

| | INTERNATIONAL SEARCH REPORT | International application No. |
|---|---|---|
| | | **PCT/CN2021/080532** |

**A. CLASSIFICATION OF SUBJECT MATTER**

H04L 1/00(2006.01)i

According to International Patent Classification (IPC) or to both national classification and IPC

**B. FIELDS SEARCHED**

Minimum documentation searched (classification system followed by classification symbols)

H04L

Documentation searched other than minimum documentation to the extent that such documents are included in the fields searched

Electronic data base consulted during the international search (name of data base and, where practicable, search terms used)

CNPAT, CNKI, WPI, EPODOC, 3GPP, IEEE: 低密度奇偶校验码, LDPC, 速率, 码率, 优先级, 顺序, 打孔, 穿孔, 删除, 校验矩阵, low density parity check, code speed, priority, rank, puncture, delete, check metrix

**C. DOCUMENTS CONSIDERED TO BE RELEVANT**

| Category* | Citation of document, with indication, where appropriate, of the relevant passages | Relevant to claim No. |
|---|---|---|
| X | CN 105490684 A (HUAQIAO UNIVERSITY) 13 April 2016 (2016-04-13) description, paragraphs 2-4, claims 1-5 | 1-21 |
| X | 周林 等 (ZHOU, Lin et al.). "可变速率多元LDPC码高阶调制系统 (Non-Binary Rate-Compatible LDPC-Coded High Order Modulation System)" 信号处理 (Journal of Signal Processing), Vol. 29, No. 10, 31 October 2013 (2013-10-31), pp. 1369-1371 | 1-21 |
| A | CN 107294543 A (UNIVERSITY OF ELECTRONIC SCIENCE AND TECHNOLOGY OF CHINA) 24 October 2017 (2017-10-24) entire document | 1-21 |
| A | US 2017149530 A1 (ELECTRONICS AND TELECOMMUNICATIONS RESEARCH INSTITUTE) 25 May 2017 (2017-05-25) entire document | 1-21 |
| A | HUAWEI et al. "LDPC coded bits interleaving and mapping to modulation symbols for HARQ retransmissions" 3GPP TSG RAN WG1 Meeting #91, R1-1720763, 01 December 2017 (2017-12-01), entire document | 1-21 |

☐ Further documents are listed in the continuation of Box C.     ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **18 May 2021** | **31 May 2021** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088 China** | |
| Facsimile No. **(86-10)62019451** | Telephone No. |

Form PCT/ISA/210 (second sheet) (January 2015)

International application No.

**PCT/CN2021/080532**

| Patent document cited in search report | | | Publication date (day/month/year) | Patent family member(s) | | | Publication date (day/month/year) |
|---|---|---|---|---|---|---|---|
| CN | 105490684 | A | 13 April 2016 | None | | | |
| CN | 107294543 | A | 24 October 2017 | None | | | |
| US | 2017149530 | A1 | 25 May 2017 | CA | 2966696 | A1 | 26 February 2016 |
| | | | | US | 2019356414 | A1 | 21 November 2019 |
| | | | | CA | 2864642 | A1 | 26 February 2016 |
| | | | | US | 2016065242 | A1 | 03 March 2016 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202010177240